(19) Europäisches Patentamt
European Patent Office
Office européen des brevets

(11) **EP 1 959 598 A1**

(12) **EUROPEAN PATENT APPLICATION**
published in accordance with Art. 158(3) EPC

(43) Date of publication:
**20.08.2008 Bulletin 2008/34**

(51) Int Cl.:
*H04J 1/00* (2006.01)          *H03M 13/19* (2006.01)
*H04J 3/00* (2006.01)          *H04J 11/00* (2006.01)
*H04L 1/00* (2006.01)          *H04Q 7/36* (2006.01)
*H04Q 7/38* (2006.01)

(21) Application number: **06834295.5**

(22) Date of filing: **08.12.2006**

(86) International application number:
**PCT/JP2006/324540**

(87) International publication number:
**WO 2007/080727 (19.07.2007 Gazette 2007/29)**

(84) Designated Contracting States:
**DE FR GB**

(30) Priority: **09.12.2005 JP 2005356702
19.06.2006 JP 2006169340**

(71) Applicant: **Mitsubishi Electric Corporation
Chiyoda-ku
Tokyo 100-8310 (JP)**

(72) Inventors:
• **YANO, Yasuhiro
Tokyo 100-8310 (JP)**
• **MATSUMOTO, Wataru
Tokyo 100-8310 (JP)**
• **FUKUI, Noriyuki
Tokyo 100-8310 (JP)**

(74) Representative: **Pfenning, Meinig & Partner GbR
Patent- und Rechtsanwälte
Theresienhöhe 13
80339 München (DE)**

(54) **COMMUNICATION METHOD AND COMMUNICATION APPARATUS**

(57) A communication method according to the present invention is a communication method that performs low density parity check (LDPC) coding to a data stream to be transmitted in a radio communication system implemented with a multi-carrier modulation method, by using a parity check matrix that has columns with uneven column degrees, the columns arranged in a descending order of the column degrees, and the communication method includes segmenting a code word into a plurality of data streams depending on number of data bits that are assignable to a radio resource block that is a unit of radio transmission, and assigning a segmented data stream having a higher column degree to a radio resource block with higher quality.

FIG.1

**Description**

TECHNICAL FIELD

The present invention relates to a communication apparatus that performs an assignment of radio resources in a broadband radio communication system by segmenting a frequency bandwidth into a plurality of blocks, and more specifically, a communication method that assigns radio resources by taking advantage of characteristics of low density parity check (LDPC) coding.

BACKGROUND ART

For example, in a known radio communication system implemented with an orthogonal frequency division multiplexing (OFDM) method, a base station included in the system transmits data according to a technology disclosed in a non-patent documentation 1. More specifically, upon transmitting data to a terminal in the service area thereof, the base station attaches a cyclic redundancy check (CRC) bit to a layer-2 protocol data unit (L2PDU), which is an input data, to detect an error. Then the base station performs an error-correcting coding (a known coding such as turbo coding) to the data attached with the CRC bit (channel coding). The base station selects if the next data is transmitted for the first time or as a retransmit (HARQ functionality including adaptive coding rate), and provides the data with a physical channel segmentation. In other words, the base station segments a frequency range available in the system into a plurality of radio resource blocks in a number instructed by a scheduler, and decides which radio resource block is to be used for the transmission of data that has been selected. Then, the base station performs adaptive modulation for each of the radio resource blocks, and transmits the modulated result.

In a known radio communication system, each of the terminals (UE: user equipment) in the service area of the base station measures quality of reception (C/I: carrier to noise power ratio), and reports a measured result to the base station. Upon performing the physical channel segmentation, for example, when a data transmission to a specific terminal is performed using two of the radio resource blocks, the scheduler in the base station assigns one of the radio resource blocks with the highest quality of reception (C/I) to the specific terminal, and the other radio resource block to the other terminal.

[Non-Patent Documentation 1] "Text Proposal on Adaptive Modulation and Channel Coding Rate Control for Frequency Domain Scheduling in Evolved UTRA Downlink" 3GPP TSG-RAN WG1 #43, R1-051307, November 7-11, 2005

DISCLOSURE OF INVENTION

PROBLEM TO BE SOLVED BY THE INVENTION

However, the above-described conventional technique does not make any reference to a radio resource assignment, which is performed by the base station, that assigns the encoded data (code word) to a plurality of radio resource blocks having different qualities of reception depending on a reliability of the encoded data with respect to each time or each frequency unit. Therefore, it is still possible to achieve further improvement from the perspectives of the performance and the capacity of the system.

The present invention has been developed in consideration of the above. Therefore, an object of the present invention is to achieve a communication method and a communication apparatus that can improve the performance and the capacity of the system.

MEANS FOR SOLVING PROBLEM

To solve the problems as described above and to achieve an object, a communication method according to the present invention is a communication method that performs low density parity check (LDPC) coding to a data stream to be transmitted in a radio communication system performing wideband transmission by using a parity check matrix that has columns with uneven column degrees, the columns arranged in a descending order of the column degrees, the communication method includes segmenting a code word into a plurality of data streams depending on number of data bits that are assignable to a radio resource block that is a unit of radio transmission, and assigning a segmented data stream having a higher column degree to a radio resource block with higher quality.

Further, a communication method according to the present invention is a communication method that performs coding to a data stream to be transmitted in a radio communication system implemented with a multi-carrier modulation method, by using channel coding that provides data conversion into a parity check matrix having columns with uneven column degrees, the columns arranged in a descending order of the column degrees, the communication method includes segmenting a code word into a plurality of data streams depending on number of data bits that are assignable to a radio resource block that is a unit of radio transmission, and assigning a segmented data stream having a higher column degree to a radio resource block with higher quality.

EFFECT OF THE INVENTION

An effect of the present invention is to improve the system performance and the system capacity, in comparison with a known technology, because a data bit stream having higher reliability is transmitted using a radio resource block with higher channel quality.

BRIEF DESCRIPTION OF DRAWINGS

[Fig. 1] Fig. 1 is a schematic diagram of a base station operating as an example of a communication apparatus according to the present invention;
[Fig. 2] Fig. 2 is a flowchart of a data transmission according to a first embodiment of the present invention;
[Fig. 3-1] Fig. 3-1 is a diagram of a radio resource assignment according to the first embodiment;
[Fig. 3-2] Fig. 3-2 is a diagram of another radio resource assignment according to the first embodiment;
[Fig. 4] Fig. 4 is a diagram of a detailed process of the radio resource assignment shown in Fig. 3-1;
[Fig. 5] Fig. 5 is a flowchart of operations of a base station and a terminal included in a radio communication system;
[Fig. 6] Fig. 6 is a diagram of a radio resource assignment according to a second embodiment of the present invention;
[Fig. 7] Fig. 7 is a flowchart of a data transmission according to the second embodiment of the present invention;
[Fig. 8] Fig. 8 is a diagram of a radio resource assignment according to a third embodiment of the present invention;
[Fig. 9] Fig. 9 is a flowchart of a data transmission according to the third embodiment;
[Fig. 10] Fig. 10 is a diagram of a radio resource assignment according to a fourth embodiment of the present invention;
[Fig. 11] Fig. 11 is a flowchart of a data transmission according to the fourth embodiment;
[Fig. 12-1] Fig. 12-1 is a schematic diagram of a "reference-signal (pilot signal)";
[Fig. 12-2] Fig. 12-2 is a diagram of an example of a symbol arrangement;
[Fig. 12-3] Fig. 12-3 is a diagram of another example of the symbol arrangement;
[Fig. 12-4] Fig. 12-4 is a diagram of still another example of the symbol arrangement;
[Fig. 12-5] Fig. 12-5 is a diagram of still another example of the symbol arrangement;
[Fig. 12-6] Fig. 12-6 is a diagram of still another example of the symbol arrangement;
[Fig. 13] Fig. 13 is a flowchart of a data transmission according to a fifth embodiment of the present invention; [Fig. 14] Fig. 14 is a flowchart of a data transmission according to the fifth embodiment;
[Fig. 15] Fig. 15 is a schematic diagram of a base station operating as another example of the communication apparatus according to the present invention;
[Fig. 16] Fig. 16 is a flowchart of a data transmission according to a sixth embodiment of the present invention; [Fig. 17] Fig. 17 is a flowchart of another data transmission according to the sixth embodiment;
[Fig. 18] Fig. 18 is a flowchart of still another data transmission according to the sixth embodiment;
[Fig. 19] Fig. 19 is a flowchart of still another data transmission according to the sixth embodiment; and
[Fig. 20] Fig. 20 is a schematic diagram of an encoder according to a seventh embodiment of the present invention.

EXPLANATIONS OF LETTERS OR NUMERALS

| 1, 1a | Radio resource scheduler |
| 2, 2a | Digital modulator |
| 3, 3a-1, 3a-m | CRC bits generator/attacher |
| 4, 4a-1, 4a-m | Channel encoder |
| 5, 5a-1, 5a-m | HARQ processor |
| 6, 6a-1, 6a-m | Data bit stream splitter |
| 7, 7a-1, 7a-m | Adaptive modulator(s) |
| 11, 12 | Recursive systematic convolutional (RSC) encoder |

BEST MODE(S) FOR CARRYING OUT THE INVENTION

Embodiments of a communication method and a communication apparatus according to the present invention will be now explained in detail with reference to the attached drawings. The embodiments included herein are not intended to limit the present invention in any way.

First Embodiment

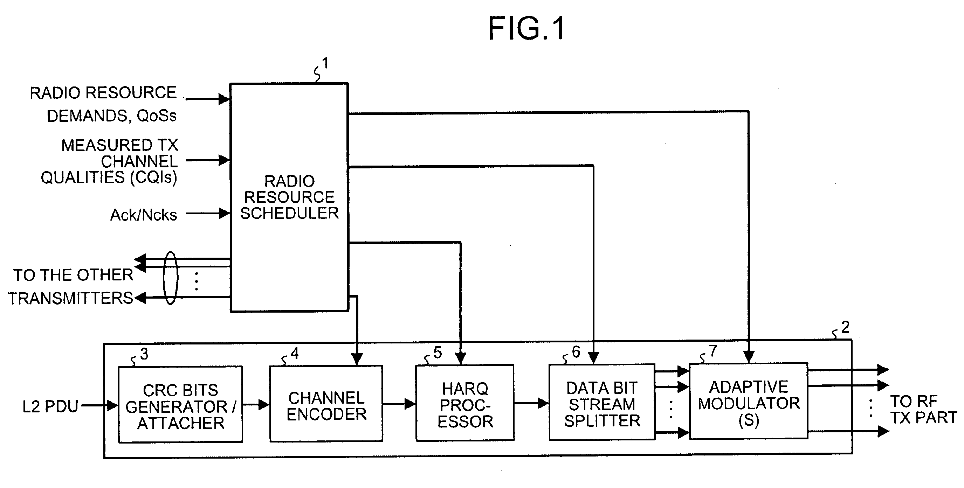

Fig. 1 is a schematic diagram of a base station operating as an example of the communication apparatus according to a first embodiment of the present invention. In the first embodiment, it is assumed that an orthogonal frequency division multiplexing (OFDM) method is adopted in a radio communication system as an example of a multi-carrier modulation scheme.

As shown in Fig. 1, the base station includes a radio resource scheduler 1 that assigns radio resources of a downlink channel, and a digital modulator 2 that transmits data based on an instruction from the scheduler 1. The digital modulator 2 has a CRC-bit generator/attacher 3, a channel encoder 4, a HARQ processor 5, a data bit stream splitter 6, an adaptive modulator(s) 7.

A general operation performed by the base station will be now explained. To assign the radio resources to each terminal for downlink transmission, the scheduler 1 in the base station receives information from each of the terminals or an upper layer. The information that the base station receives includes radio resource demands, qualities of service (QoS) that are predicted from the radio resource demands, measured tx channel qualities (CQIs: Channel Quality Indicators) that are qualities of downlink channels reported via uplink channels, and delivery acknowledgements (Ack/Ncks) related to downlink transmission and reception.

To perform the downlink transmission efficiently, the scheduler 1 determines a presence of a transmission for each of the radio resource demands, the number of bits included in transmitted information, an encoding ratio of the channel encoding, HARQ information, the number of radio resource blocks used for the transmission, and an adaptive modulation scheme used for each of the radio resource blocks. The downlink transmission is performed based on these determinations made by the scheduler 1. Details about the radio resource block will be explained later.

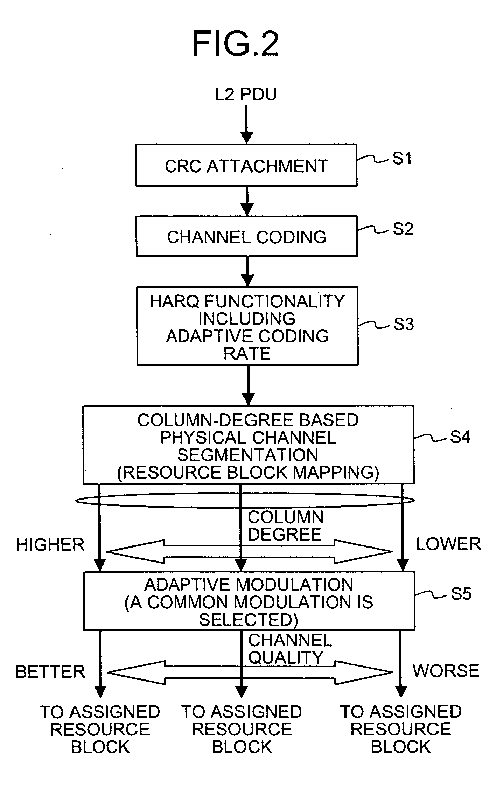

A specific procedure for the downlink transmission will be now explained. Fig. 2 is a flowchart of a data transmission performed by the base station according to the first embodiment. The digital modulator 2 receives the following information: a layer-2 protocol data unit (L2PDU), which is a unit of the transmitted data, sent as a part of a radio resource demand from the upper layer; a coding rate for the channel coding sent from the scheduler 1; HARQ information and the number of bits in the transmitted information (HARQ method, number of tx data bits); the number of the radio resource blocks; the number of data bits assigned to each of the radio resource blocks, and a total number thereof (total and split tx data bits); and information about modulation scheme(s) applied to each of the radio resource blocks. The information about the modulation scheme(s) is attached with the channel quality information for the radio resource blocks, and the channel quality information is used when a transmission is made using a plurality of radio source blocks, for example, to assign radio resource blocks from the ones with the highest channel quality.

At the base station, the CRC-bit generator/attacher 3 attaches the CRC bit to the L2PDU, which is the input data, based on the number of data bits included in the L2PDU (step S1: CRC attachment). The channel encoder 4 performs the error-correcting coding based on the received coding rate (step S2: Channel coding). For this coding, irregular-LDPC coding is performed using a parity check matrix with uneven column-degrees (column-weights). After the LDPC coding, the bit stream (code word) is output based on the column-degrees in the parity check matrix, for example, from the bit with the highest weight (with the highest column-degree).

The HARQ processor 5 selects a transmitted portion of the coded bit stream (newly-transmitted data, or retransmitted data) based on the received HARQ information and the number of bits in the transmitted information, and outputs the selected portion of the bit stream (step S3: HARQ functionality including adaptive coding rate). At this time, the HARQ processor 5 ensures that the order in the bit stream that is output from the channel encoder 4 is kept unchanged.

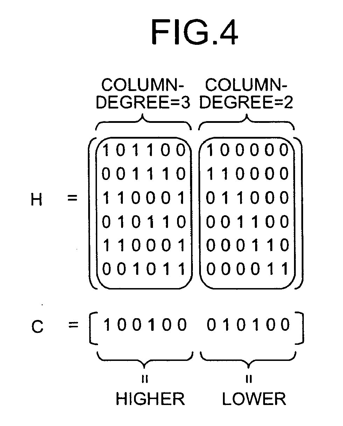

The data bit stream splitter 6 segments the bit stream (code word) received from the HARQ processor 5 into a predetermined number based on the number of allocated radio resource blocks, the number of data bits assigned to each of the radio resource blocks, and the column-degrees in the parity check matrix. This segmentation will be explained in detail later (see Fig. 4). Each of the segmented bit streams is output in a descending order of the weights thereof (step S4: column-degree based physical channel segmentation).

At the final step, the adaptive modulator(s) 7 performs a predetermined modulation to each of the segmented bit streams, based on the given modulation scheme information. Based on the channel qualities of the radio resource blocks that is attached to the modulation scheme information, each modulated symbol is assigned to each of the radio resource blocks, for example, so that the symbol with the highest weight is assigned to the radio resource block with the highest channel quality (step S5: Adaptive modulation). The output from the adaptive modulator(s) 7 is passed over to a radio frequency transmitter (RF tx part) (not shown), and transmitted over a radio channel at a frequency range of the radio resource blocks.

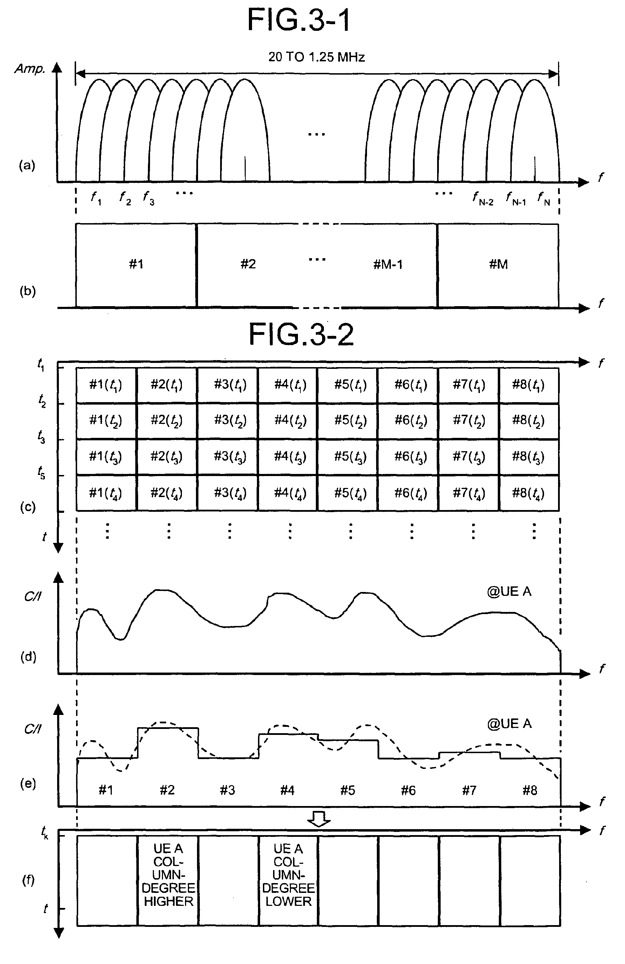

A communication method according to the first embodiment will be now explained in detail with reference to the attached drawings. Fig. 3 (Fig. 3 refers to Fig. 3-1 and Fig. 3-2) is a diagram of radio resource assignment according to the first embodiment. Fig. 3-1(a) depicts the system range in a system using the ODFM method as a modulation scheme. In the first embodiment, N sub-carriers ($f_1$ to $f_N$) in a bandwidth between 20MHz to 1.25MHz are assumed, and a predetermined modulation (QPSK, 16QAM, 64QAM, for example) is performed for each of the sub-carriers. Fig. 3-1(b) depicts segmentation of the system range shown in Fig. 3-1(a) into M resource blocks (chunks). This radio resource blocks can be identified by a specified number of the sub-carriers and a specified number of the symbols.

Fig. 3-2(c) depicts a relationship between frequency and time when the number of the radio resource block (=M) is "8". The radio resource blocks corresponding to each time unit (TTI: Transmission Time Interval) are shown in this diagram. Here, #1 to #8 are radio resource block numbers, and t1, t1, t3, t4.... are time numbers. The radio resource blocks include seven OFDM symbols, for example.

Fig. 3-2(d) depicts a channel quality (C/I: carrier to noise ratio) measured by a terminal (UE) A located in the service area of the base station, and depicts how the channel quality changes at each frequency due to frequency-selective fading. Fig. 3-2(e) depicts the channel quality (C/I), for each of the radio resource blocks, transmitted by the terminal A to the base station.

Fig. 3-2(f) depicts how the terminal A transmits data using two of the radio resource blocks. According to the first embodiment, the scheduler 1 assigns the terminal A with two radio resource blocks #2 and #4 with higher channel qualities (C/I). The remaining radio resource blocks can be assigned to other terminals B, C ... (not shown). Moreover, according to the first embodiment, upon assigning resources to these two radio resource blocks #2 and #4, for example, out of two data streams segmented by the data bit stream splitter 6, the data stream including more bits with higher column-degrees (higher weights) is assigned to the radio resource block #2 with the highest channel quality (column-degree higher), and the data stream including more bits with lower column-degrees (lower weights) is assigned to the radio resource block #4 with the second highest channel quality (column-degree lower).

Fig. 4 is a diagram of detailed process of the radio resource assignment shown in Fig. 3-2(f). In Fig 4, it is assumed that channel encoder 4 generates a parity check matrix H and a generating matrix G with uneven column-degree (G satisfies $GH^T=0$ (where T represents a transposed matrix)), and that the code word C is generated by an operation of "C=DxG", based on the generating matrix G and a data stream D received from the CRC-bit generator/attacher 3. The parity check matrix H and the generating matrix G may also be generated in advance and stored in a memory.

In the first embodiment, as shown in Fig. 4, the parity check matrix H is generated so as to have columns arranged in the descending order of column-degrees, and the code word C is generated with the parity check matrix H having this characteristic. For example, upon segmenting the received data stream (code word) based on the instruction from the scheduler 1, the data bit stream splitter 6 segments the code word C into a data stream with more bits corresponding to the columns with a higher column-degree in the parity check matrix H (a data stream with high column-degree), and the other data stream having more bits corresponding to the columns with a lower column-degree (a data stream with low column-degree), as shown in Fig. 4. Upon comparing the data stream having more bits corresponding to the columns with a higher column-degree to the other data stream having more bits corresponding to the columns with a lower column-degree, it is already known that the former is higher in reliability. The data stream with higher column-degree, that is, the data stream with higher reliability, is assigned to the radio resource block having the highest channel quality (column-degree higher), and the other data stream is assigned to the radio resource block having the second highest channel quality (column-degree lower).

In Fig. 4, a half of the parity check matrix H is allocated with the degree of 3, and another half is allocated with the degree of 2. However, the arrangement of columns in the parity check matrix H is not limited to the above. Any parity check matrix can be used as long as the degree is allocated unevenly, and the columns are arranged in the descending order of the column-degrees. For the convenience of explanation, the bit stream splitter 6 herein is assumed to segment the data stream into two. However, the data stream may be segmented into three, four, or more segments based on the instruction received from the scheduler 1 (the number of data bits assigned to each of the radio source blocks). If the data stream is to be segmented into three, four, or more then, the data stream including the bits corresponding to the highest column-degree is assigned to the radio resource block with the highest quality.

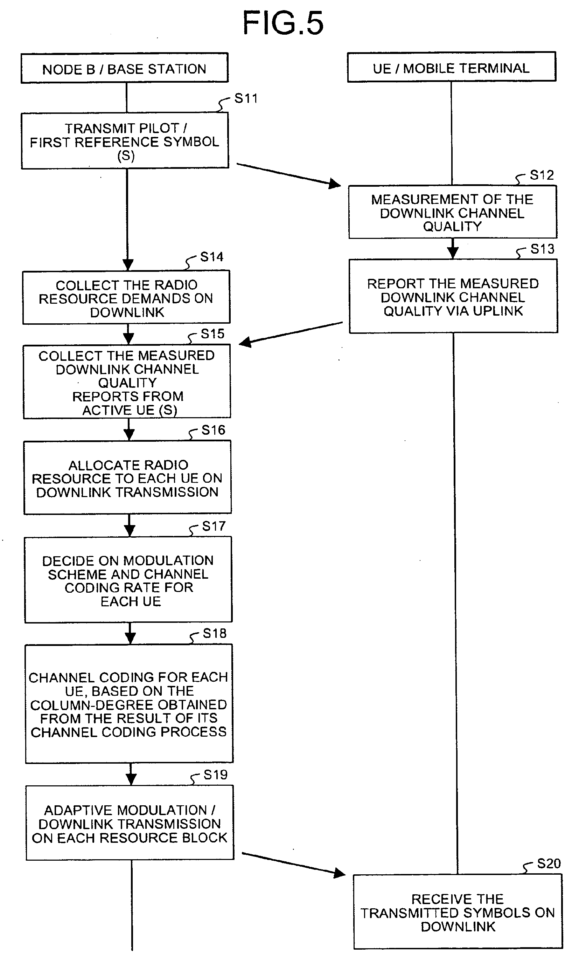

A radio communication system, including the base station according to the first embodiment, is explained with reference to the drawings. Fig. 5 is a flowchart of operations performed by a base station (node B) and a terminal (UE) included in the radio communication system.

The base station sends a known signal (a "pilot" or a "first reference symbol") to the terminals belonging to the base station to measure the reception quality over the downlink channel (downlink quality) (step S11: Transmit pilot/first reference symbol(s)). Upon receiving the known signal, each of the terminals measures a quality of the downlink channel using the known signal (step S12: Measurement of the downlink channel quality), and reports a result of the measurement to the base station (step S13: Report the measured downlink channel quality via uplink). While receiving the measurement results from the terminal (step S15: Collect the measured downlink channel quality reports from active UE(s)), the base station collects the radio resource demands for the downlink transmission from the upper layer or the like (step S14: Collect the radio resource demands on downlink).

The base station assigns the radio resource for the downlink transmission to each of the terminals based on the radio resource demands for the downlink transmission and the qualities of downlink channels collected at the steps described above (step S16: allocate radio resource to each UE on downlink transmission), and determines transmission parameters, such as the coding rates and the coding rate for each of the terminals (step S17: Decide on modulation scheme and channel coding rate for each UE). At this time, the base station performs the processes shown in Figs. 2 to 4, and performs radio transmission through the frequency range assigned by each of the radio resource blocks (steps S18, S19). Each of the terminals receives the downlink transmission signal (step S20: Receive the transmitted symbols on downlink).

In the manner described above, in the first embodiment, assuming that the LDPC coding is performed with the parity check matrix having uneven column-degrees and columns arranged in descending order of the column-degrees, for example, the code word is segmented into a plurality of data streams, and the segmented data stream with most bits corresponding to the highest column-degree in the parity check matrix is assigned to a radio resource block with a high channel quality. In other words, the data stream having higher reliability is transmitted with a radio resource block with a high channel quality. Therefore, a transmission with higher error-correction capability is achieved, that is, more efficient transmission can be achieved, in comparison with a known technology. Thus, the performance and the capacity of the system can be further improved.

In the first embodiment, the explanation is provided for the downlink transmission as an example. However, the radio resource assignment based on the reliability of the code word can be also applied to the uplink transmission.

Second Embodiment

A communication method according to a second embodiment of the present invention will be now explained. In the first embodiment, for example, the same common adaptive modulation is applied to each of the radio resource blocks. On the contrary, according to the second embodiment, the adaptive modulation is applied individually to each of the radio resource blocks. The base station used for realizing the communication method according to the second embodiment has the same structure as that according to the first embodiment shown in Fig. 1. In the second embodiment, explanations are provided only for processes that are different from those according to the first embodiment.

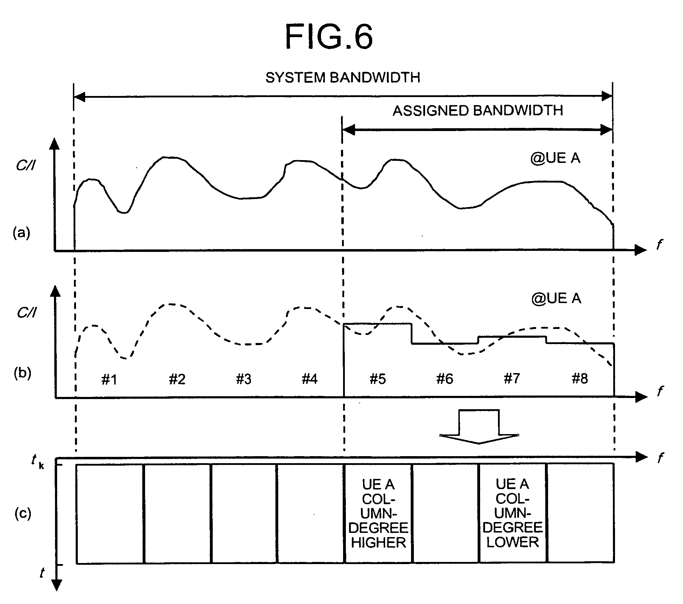

The communication method according to the second embodiment will be now explained in detail with reference to the drawings. Fig. 6 includes diagrams of a radio resource assignment according to the second embodiment. More specifically, Fig. 6(a) depicts a channel quality (C/I) measured by a terminal (UE) A in the service area of the base station, and shows that the channel quality changes at each frequency due to frequency-selective fading. Fig. 6(b) depicts the channel quality (C/I), for each of the radio resource blocks, transmitted from the terminal A to the base station. According to the second embodiment, the radio resource blocks assignable to the terminal A are limited in advance (in Fig. 6, limited to #5 to #8). As shown in Fig. 6(b), the terminal reports the channel quality for the radio resource blocks #5 to #8 to the base station.

Fig. 6(c) depicts how the terminal A transmits data using two of the radio resource blocks. According to the second embodiment, the scheduler 1 assigns the radio resource blocks #5 and #7 with high channel qualities, from the radio resource blocks #5 to #8 that are assignable to the terminal A. According to the second embodiment, upon assigning resources, that is, assigning the two data streams segmented by the data bit stream splitter 6 to these two radio resource blocks #5 and #7, for example, the data stream including more bits with the higher column-degree (higher weight) is assigned to the radio resource block #5 with the highest channel quality (column-degree higher), and the data stream including more bits with the lower column-degree (lower weight) is assigned to the radio resource block #7 with the second highest channel quality (column-degree lower).

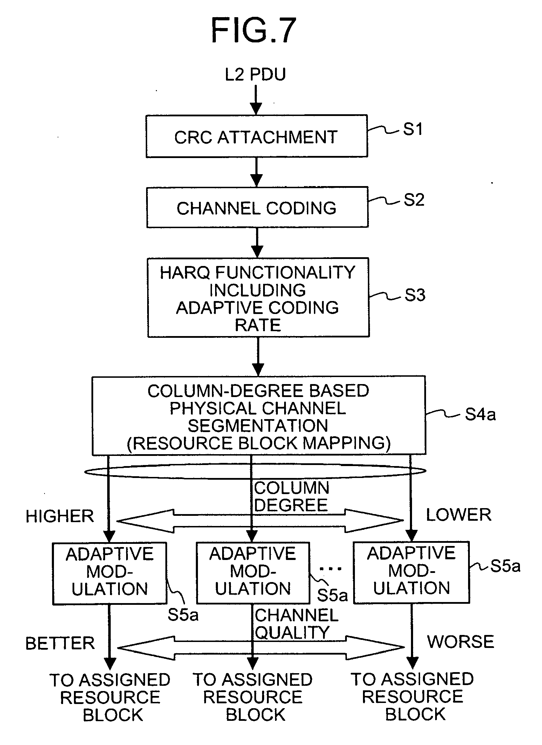

A specific process of a downlink transmission according to the second embodiment will be now explained. Fig. 7 is a flowchart of a data transmission performed by the base station according to the second embodiment. The steps S1 to S3 are the same as those according to the first embodiment.

For example, upon segmenting the data stream (code word) into two based on an instruction from the scheduler 1, the data bit stream splitter 6 segments the code word C into a data stream including more bits corresponding to columns with the higher column-degree in the parity check matrix H (the data stream with high column-degree), and a data stream including more bits corresponding to columns with the lower column-degree (the data stream with low column-degree), as shown in Fig. 4. The data stream with the high column-degree, that is, the data stream with higher reliability, is assigned to the radio resource block with the highest channel quality, from the limited radio resource blocks. The other data stream is assigned to the radio resource block with the second highest channel quality, from the limited radio resource blocks (step S4a).

The adaptive modulator(s) 7 modulates each of the resource blocks based on the received modulation scheme information (step S5a). According to the second embodiment, since the adaptive modulation is applied to each of the radio resource blocks, the number of data bits that can be assigned to each of the radio resource blocks may not necessarily the same. Therefore, in the second embodiment, the data bit stream splitter 6 segments the code word in the number of bits assignable to a specified radio resource block.

As described above, according to the second embodiment, the data stream with higher reliability is transmitted with the radio resource block having higher channel quality, in the same manner as in the first embodiment. Therefore, it is possible to achieve the same effects as those according to the first embodiment. Furthermore, according to the second embodiment, the limitation is given to the radio resource blocks assignable to each of the terminals in advance. By way of this limitation, the terminals and the base station can be offloaded.

Although the radio resource blocks assignable to the terminal A are in the range of #5 to #8 in the second embodiment, the assignable radio resource blocks are not limited to these described above. The assignable radio resource blocks may be located anywhere as long as they are within the system range.

Third Embodiment

A communication method according to a third embodiment of the present invention will be now explained. According to the first and the second embodiments, the radio resource is assigned based on the downlink channel quality sent by the terminals. On the contrary, according to the third embodiment, the radio resource is assigned without using the downlink channel qualities. The base station used for realizing the communication method according to the third embodiment has the same structure as that according to the first embodiment shown in Fig. 1. In the third embodiment, explanations are provided only for processes that are different from those according to the first and the second embodiments.

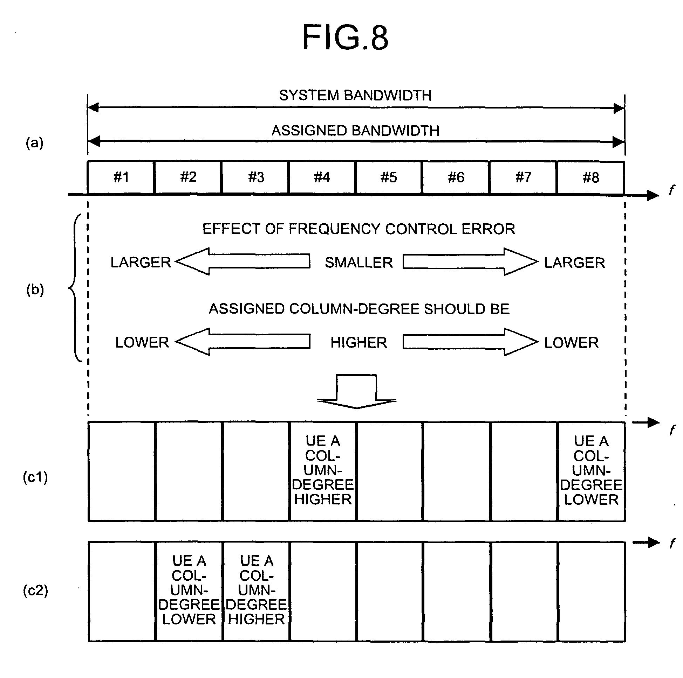

The communication method according to the third embodiment will be now explained in detail with reference to the drawings. Fig. 8 includes diagrams of a radio resource assignment according to the third embodiment. More specifically, Fig. 8(a) depicts a system range, and assignable radio resource blocks. In this drawing, the radio resource blocks #1 to #8, which is the entire system range, can be assigned to the terminal A.

Fig. 8(b) depicts a specific example of the radio resource assignment according to the third embodiment. In a broadband system, for example, the carrier is synchronized near the center of the system range. Because the carrier synchronization is established near the center of the system range (with a small frequency error), the error (the effect of a frequency control error) can be reduced (smaller). The further away toward the edges of the system range, the greater the frequency error becomes, causing more errors (larger). In other words, it can be said that, in a broadband system, the nearer to the center of the system range, the better the transmission quality will be in a production operation.

Figs 8(c1) and 8(c2) depict how the terminal A transmits data using two of the radio resource blocks. According to the third embodiment, the scheduler 1 assigns at least one radio resource block located near the center of the system range, from the radio resource blocks #1 to #8 that are assignable to the terminal A. More specifically, upon assigning resources to these two radio resource blocks #4 and #8 as shown in Fig. 8(c1), for example, out of two data streams segmented by the data bit stream splitter 6, the data stream including more bits with the higher column-degree (higher weight) is assigned to the radio resource block #4 closer to the center of the system range (column-degree higher), and the data stream including more bits with the lower column-degree (lower weight) is assigned to the radio resource block #8 (column-degree lower). Upon assigning resources to these two radio resource blocks #2 and #3 as shown in Fig. 8 (c2), for example, out of two data streams segmented by the data bit stream splitter 6, the data stream including more bits with the higher column-degree (higher weight) is assigned to the radio resource block #3 nearer to the center of the system range (column-degree higher), and the data stream including more bits with the lower column-degree (lower weight) is assigned to the radio resource block #2 (column-degree lower).

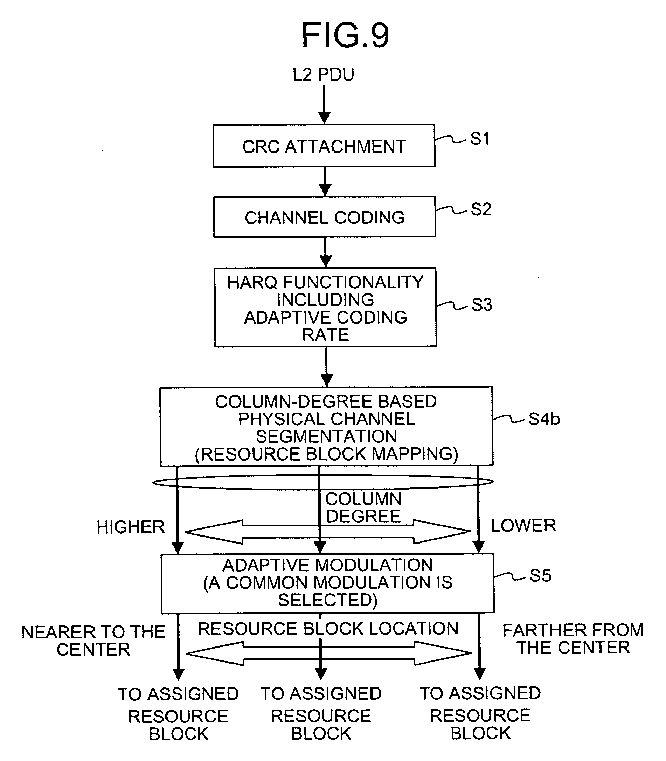

A specific process of a downlink transmission according to the third embodiment will be now explained. Fig. 9 is a flowchart of a data transmission performed by the base station according to the third embodiment. The steps S1 to S3 and S5 are the same as those according to the first embodiment.

For example, upon segmenting the data stream (code word) into two based on an instruction from the scheduler 1, the data bit stream splitter 6 segments the code word C into a data stream including more bits corresponding to columns with the higher column-degree in the parity check matrix H (data stream with high column-degree), and the other data stream including more bits corresponding to columns with the lower column-degree (data stream with low column-degree), as shown in Fig. 4. The data stream with high column-degree, that is, the data stream with higher reliability, is assigned to the radio resource block that is the nearest to the center of the system range, and the other data stream is assigned to the radio resource block that is the second nearest to the center of the system range (step S4b). Subsequently, the adaptive modulator(s) 7 performs the adaptive modulation based on the given modulation scheme information, in the same manner as in the first embodiment (step S5).

As described above, according to the third embodiment, the data stream with the higher reliability is transmitted with the radio resource block having a high channel quality, in the same manner as in the first embodiment. Therefore, it is possible to achieve the same effects as those according to the first embodiment. Furthermore, according to the third embodiment, the radio resource is assigned without depending on the downlink channel qualities sent from the terminals. Therefore, the terminals and the base station can be further offloaded.

Fourth Embodiment

A communication method according to a fourth embodiment of the present invention will be now explained. In the fourth embodiment, the process according to the second embodiment, that is to limit the radio resource blocks assignable to the terminals in advance, is applied to the third embodiment. The base station used for realizing the communication method according to the fourth embodiment has the same structure as that according to the first embodiment shown in Fig. 1. In the fourth embodiment, explanations are provided only for processes that are different from those according to the first to the third embodiments.

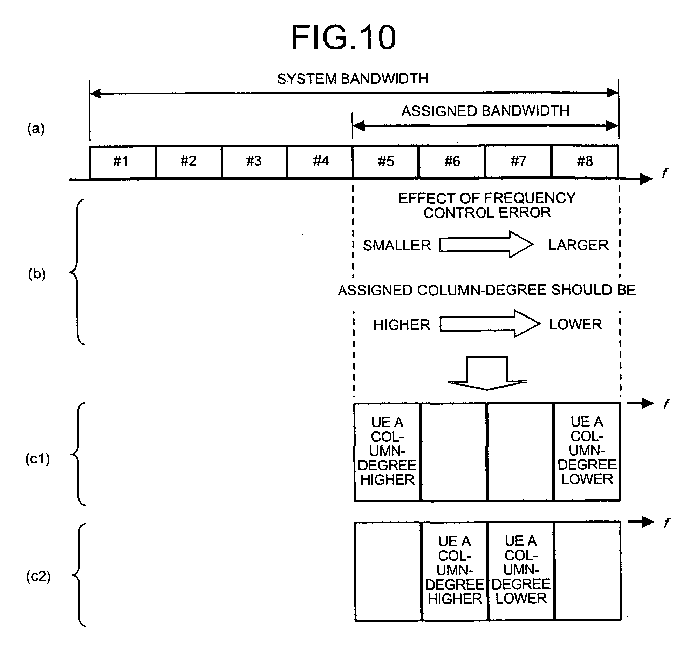

The communication method according to the fourth embodiment will be now explained in detail with reference to the drawings. Fig. 10 is a diagram of a radio resource assignment according to the fourth embodiment. More specifically, Fig. 10(a) depicts a system range and assignable radio resource blocks. In this drawing, the radio resource blocks #5 to #8, which are in the right half of the system range, can be assigned to the terminal A. Fig. 10(b) depicts a specific example of the radio resource assignment according to the fourth embodiment. Because the carrier synchronization is established near the center of the system range (#5) (with a small frequency error), the error (the effect of the frequency control error) is reduced (smaller). The further away toward the edges of the system range (#5→#8), the greater the frequency error becomes, causing more errors (larger).

Figs. 10(c1) and (c2) depict how the terminal A transmits data using two of the radio resource blocks. In the fourth embodiment, the scheduler 1 assigns at least one radio resource block near the center of the system range, from the radio resource blocks #5 to #8 assignable to the terminal A. More specifically, upon assigning resources to these two radio resource blocks #5 and #8 as shown in Fig. 10(c1), for example, out of two data streams segmented by the data bit stream splitter 6, the data stream including more bits with the higher column-degree (higher weight) is assigned to the radio resource block #5 near the center of the system range (column-degree higher), and the data stream including more bits with the lower column-degree (lower weight) is assigned to the radio resource block #8 (column-degree lower). Upon assigning resources to these two radio resource blocks #6 and #7 as shown in Fig. 10(c2), for example, out of two data streams segmented by the data bit stream splitter 6, the data stream including more bits with the higher column-degree (higher weight) is assigned to the radio resource block #6 nearer to the center of the system range (column-degree higher), and the data stream including more bits with the lower column-degree (lower weight) is assigned to the radio resource block #7 (column-degree lower).

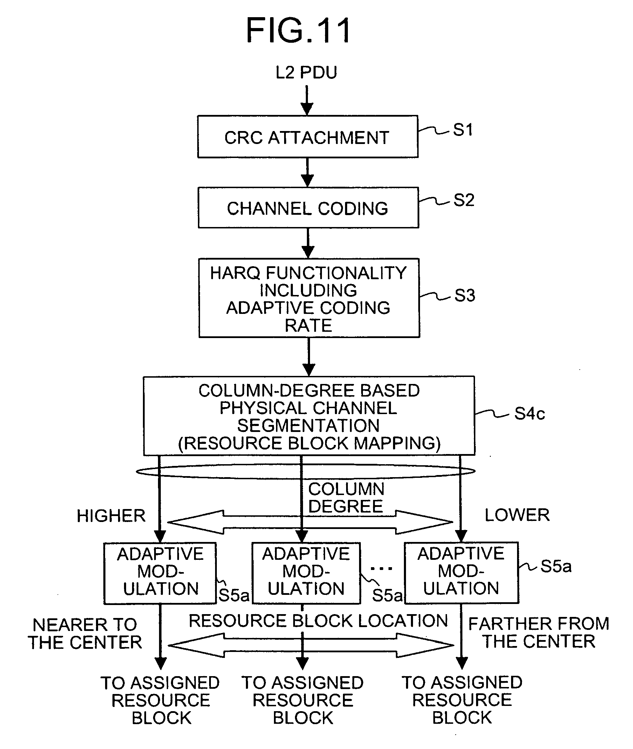

A specific process of a downlink transmission according to the fourth embodiment will be now explained. Fig. 11 is a flowchart of a data transmission performed by the base station according to the fourth embodiment. The steps S1 to S3 and S5a are the same as those according to the first embodiment.

For example, upon segmenting the data stream (code word) into two based on an instruction from the scheduler 1, the data bit stream splitter 6 segments the code word C into a data stream including more bits corresponding to columns with the higher column-degree in the parity check matrix H (the data stream with high column-degree), and the other data stream including more bits corresponding to columns with the lower column-degree (the data stream with low column-degree), as shown in Fig. 4. The data stream with the high column-degree, that is, the data stream with higher reliability, is assigned to the radio resource block that is nearest to the center of the system range, from the limited radio resource blocks. The other data stream is assigned to the radio resource block that is the second nearest to the center of the system range (step S4c). Subsequently, the adaptive modulator(s) 7 performs the adaptive modulation based on the given modulating scheme information, in the same manner as in the second embodiment (step S5a).

As described above, according to the fourth embodiment, the data stream with higher reliability is transmitted with the radio resource block having a high channel quality, in the same manner as in the first embodiment. Therefore, it is possible to achieve the same effects as those according to the first embodiment. Furthermore, according to the forth embodiment, the limitation is given to the radio resource blocks assignable to each of the terminals in advance, and the radio resource is assigned without depending on the downlink channel quality sent from the terminals. Thus, the terminals and the base station can be further offloaded.

Fifth Embodiment

A communication method according to a fifth embodiment of the present invention will be now explained. According to the first to the fourth embodiments, the code word is segmented into a plurality of data streams, and the data stream with higher reliability is transmitted with a radio resource block with a higher quality. On the contrary, according to the fifth embodiment, it is specified how the data streams, obtained by the processes according to the first to the fourth embodiments, are assigned to each of the radio resource blocks. The base station used for realizing the communication method according to the fourth embodiment has the same structure as that according to the first embodiment shown in Fig. 1, and the number of the radio resource blocks in question is an integer equal to or greater than 1. In the fifth embodiment, explanations are provided only for processes that are different from those according to the first to the fourth embodiments.

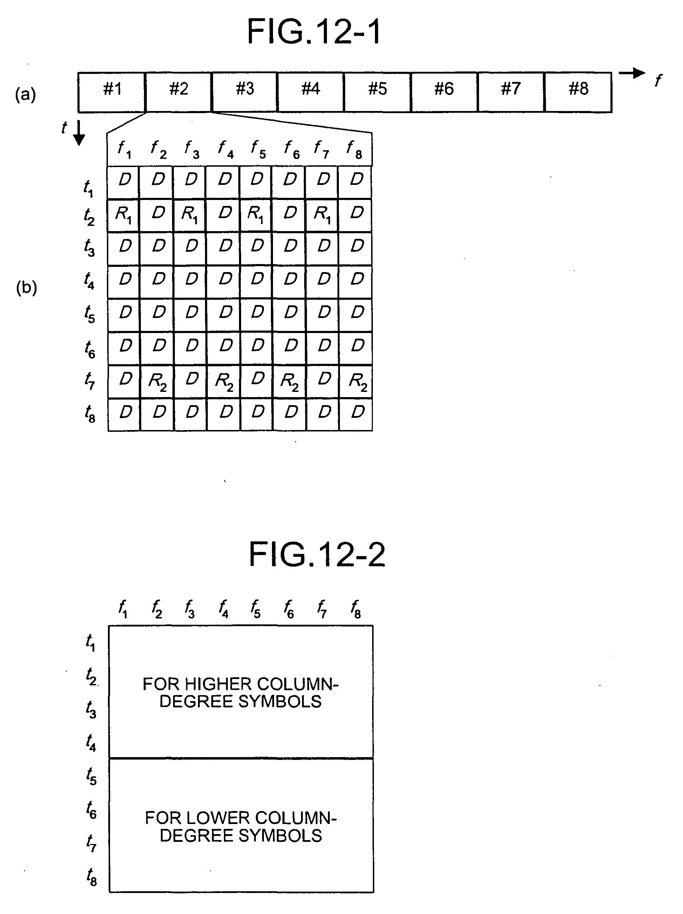

For example, Fig. 12-1 is a schematic diagram of the "reference signal (pilot signal)" disclosed in the document "Text proposal for 7.1.1.2.2 (Downlink reference-signal structure)" 3GPP TSG-RAN WG1 #43, R1-051599, November 7-11, 2005. More specifically, Fig. 12-1 depicts an example where the "reference signal" is transmitted with the radio resource block #2 in the system range (it is assumed here that the system range includes radio resource blocks #1 to #8). In this drawing, the single radio resource block includes eight sub-carriers $f_1$ to $f_8$ and eight symbols $t_1$ to $t_8$. Here, D shown in the drawing denotes to a "data symbol", $R_1$ denotes to a "first reference symbol", and $R_2$ denotes to a "second reference symbol". Here, $R_1$ and $R_2$ are symbols used for measuring the channel qualities, and the area around them generally have high qualities.

Using Fig. 12-1 as an assumption, according to the fifth embodiment, an arrangement of the symbols in the radio resource block is specified depending on the column-degree as follows.

For example, when $R_2$ is not being used, the higher column-degree symbols are arranged near $R_1$ where the quality is high, and the lower column-degree symbols are arranged elsewhere as shown in Fig. 12-2.

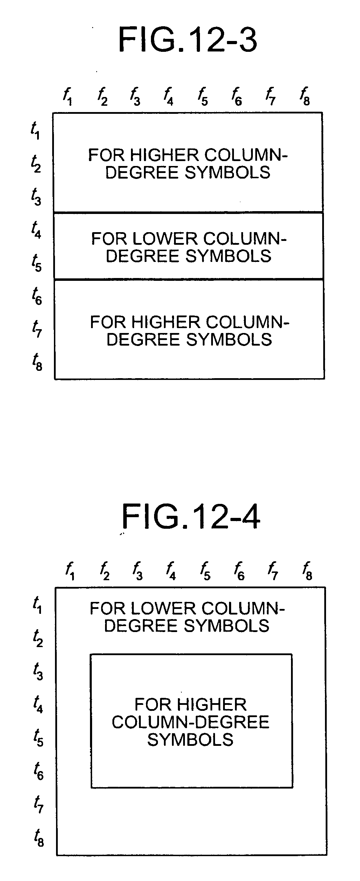

When $R_2$ is used in addition to $R_1$, the higher column-degree symbols are arranged near $R_1$ and $R_2$ where the qualities are high, and the lower column-degree symbols are arranged elsewhere as shown in Fig. 12-3.

Another symbol arrangement, which is different from those shown in Figs. 12-2 and 12-3, will be now explained.

For example, if a particular communication apparatus (a terminal, a base station) performs a transmission intermittently using a single radio resource block, the sub-carriers located near to one of the edges of this radio resource block become susceptible to an interference from adjacent sub-carriers in the adjacent radio resource blocks. If a transmission is performed intermittently, also along the time direction, an amplifier power might be caused to turn ON and OFF, and the operation might become unstable around $t_1$, $t_2$, $t_7$, and $t_8$. In addition, the operation can be influenced easily by a timing shift that is caused upon transmitting the radio resource blocks prior and subsequent thereto.

Thus, in the fifth embodiment, the higher column-degree symbols are arranged at a position near to the center of the radio resource block (where the quality is high), and the lower column-degree symbols are arranged around the right, left, upper, or lower edges thereof (where the quality is low), for example, as shown in Fig. 12-4.

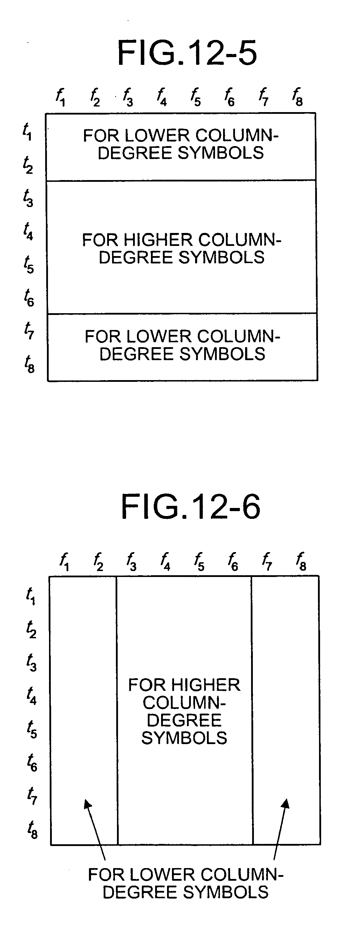

Assuming that a particular communication apparatus is making an intermittent transmission using a radio resource block whose frequencies are adjacent to each other (without being influenced by the interference thereof), the symbols may be also arranged in the manner as shown in Fig. 12-5. Specifically, the higher column-degree symbols may be arranged at a position near to the center of the radio resource block along the time direction (where the quality is high), and the lower column-degree symbols are arranged around the upper and the lower edges thereof (where the quality is low).

Moreover, assuming a particular communication apparatus (a terminal, a base station) making continuous transmissions using a single radio resource block, the symbols may be arranged in the manner as shown in Fig. 12-6. Specifically, the higher column-degree symbols may be arranged at a position near to the center of the radio resource block along the frequency direction (where the quality is high), and the lower column-degree symbols may be arranged around the right and the left edges thereof (where the quality is low).

Moreover, it is possible to switch among the symbol arrangements shown in Figs. 12-4, 12-5, and 12-6 depending on how the radio resource blocks are being used.

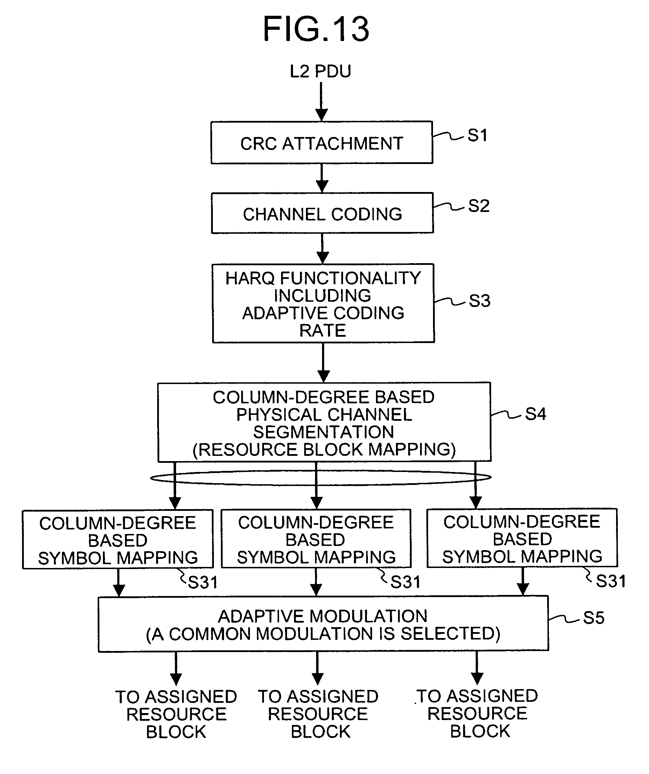

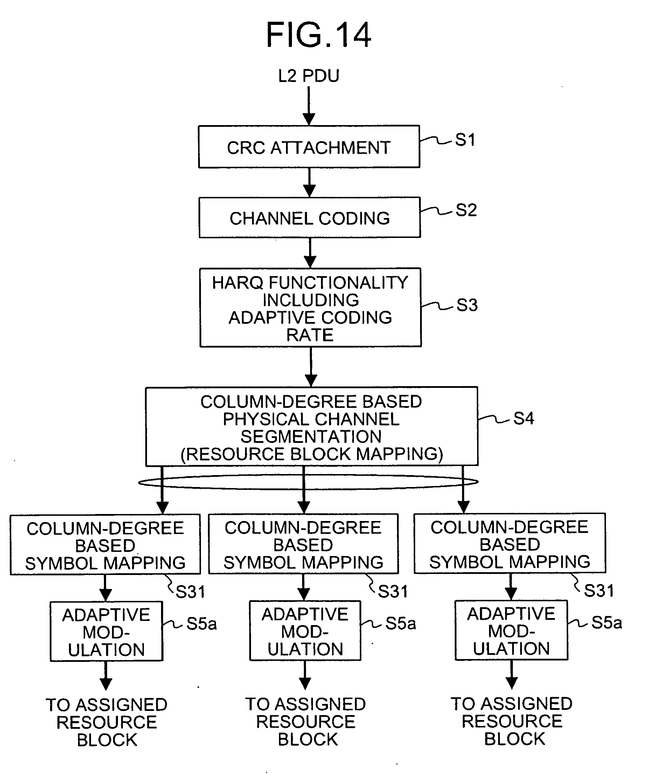

A specific process of a downlink transmission according to the fifth embodiment will be now explained. Figs. 13 and 14 are flowcharts of data transmissions performed by the base station according to the fifth embodiment. Specifically, Fig. 13 is a transmission corresponding to Fig. 2 according to the first embodiment, and Fig. 14 is a transmission corresponding to Fig. 7 according to the second embodiment.

For example, according to the fifth embodiment, in the data streams that have been segmented by the process at step S4, one of the symbol arrangements shown in Figs. 12-2 to 12-6 is applied (step S31). The process at the step S31 may be also applied to Fig. 9 according to the third embodiment and Fig. 11 according to the fourth embodiment, in the same manner.

As described above, according to the fifth embodiment, the code word is segmented into a plurality of data streams, and the data stream with a higher reliability is transmitted with a radio resource block having a higher channel quality, in the manner explained above for the first to the fourth embodiments. In addition to these processes, one of the symbol arrangements that is dependent on the reliability of the data stream of the code word, shown in Figs. 12-2 to 12-6, is applied to each of the radio resource blocks. In this manner, the system performance and the system capacity can be further improved.

Sixth Embodiment

A communication method according to a sixth embodiment of the present invention will be now explained. In the explanation of the first to the fifth embodiments, the data included only one type. On the contrary, in the explanation of the sixth embodiment, the data will include a plurality of types. In the sixth embodiment, explanations are provided only for processes that are different from those according to the first to the fifth embodiments.

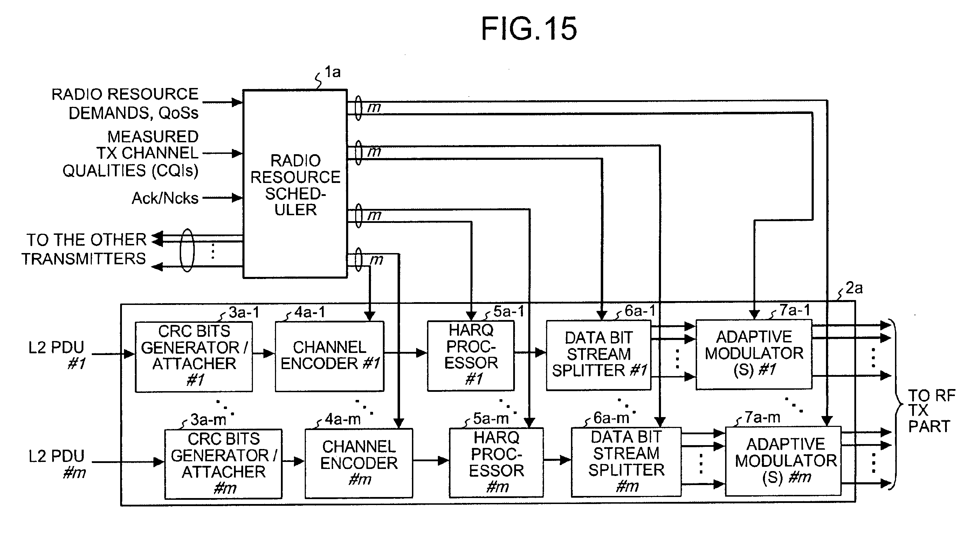

Fig. 15 is a schematic diagram of a base station operating as an example of the communication apparatus according to the present invention. In Fig. 15, the base station includes a radio resource scheduler 1a that performs assignment of the downlink radio resources, and a digital modulator 2a that transmits m types of data (where m is an integer satisfying the condition "1≤m≤M") based on an instruction from the scheduler 1a. The digital modulator 2a further includes CRC bits generators/attachers 3a-1 to 3a-m, channel encoders 4a-1 to 4a-m, HARQ processors 5a-1 to 5a-m, data bit stream splitters 6a-1 to 6a-m, and adaptive modulators 7a-1 to 7a-m. The digital modulator 2a includes the digital modulator 2, shown in Fig. 1, that is independent for each data type unit (such as voice, data, or control information).

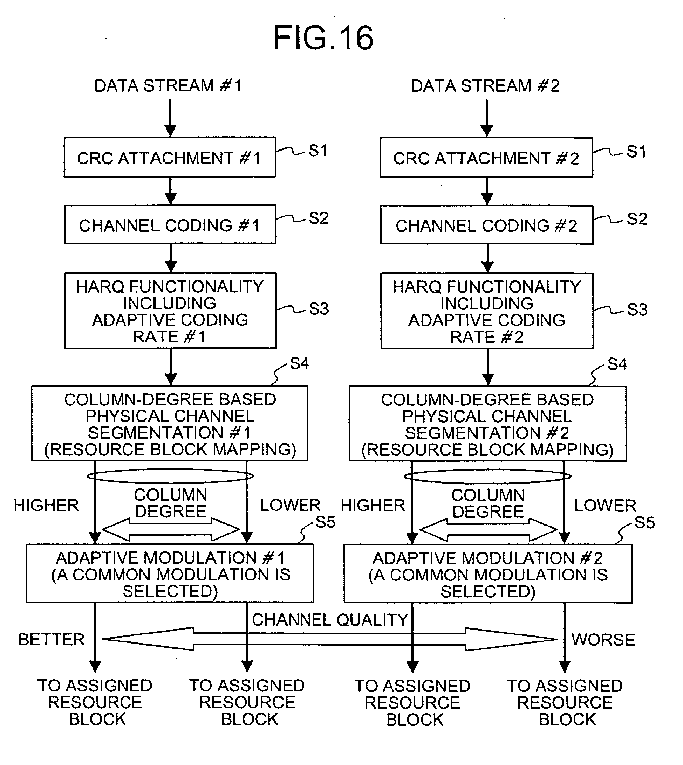

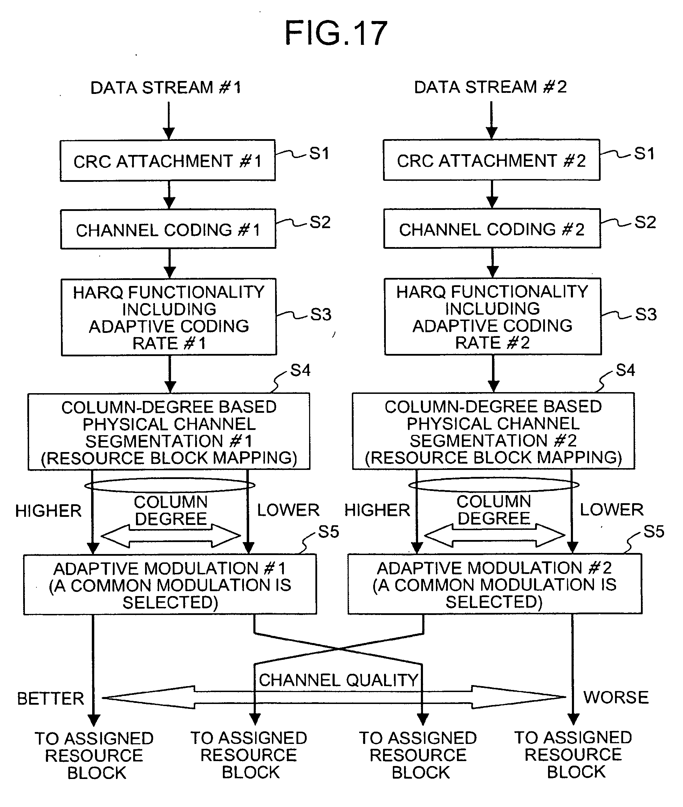

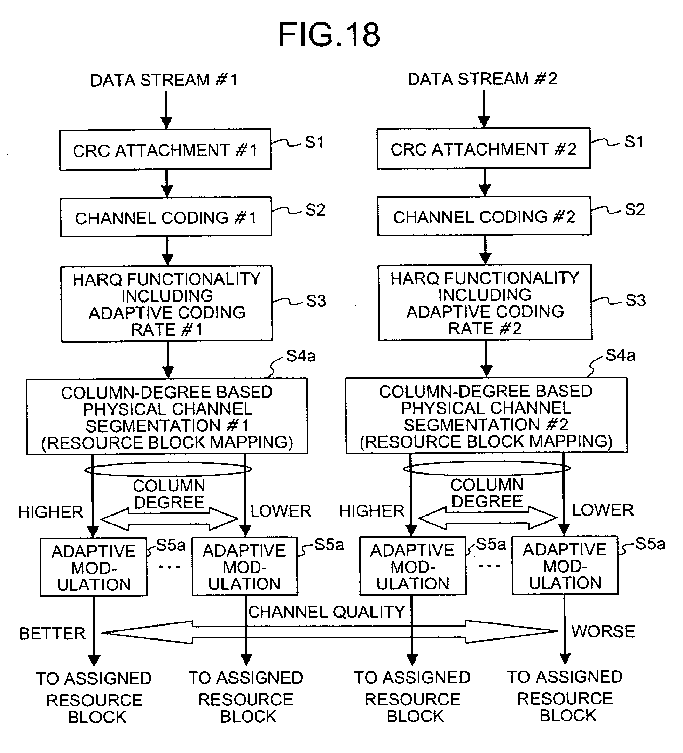

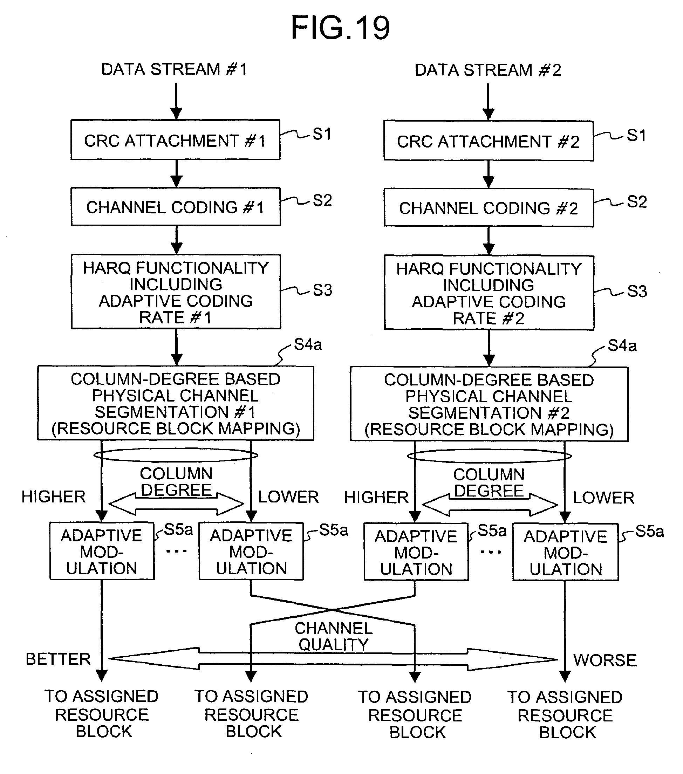

A specific process of a downlink transmission according to the sixth embodiment will be now explained. Figs. 16, 17, 18 and 19 are respectively flowcharts of data transmission performed by the base station according to the sixth embodiment. Specifically, Figs. 16 and 17 are transmissions corresponding to Fig. 2 according to the first embodiment, and Figs. 18 and 19 are transmissions corresponding to Fig. 7 according to the second embodiment.

For example, in Figs. 16, 17, 18, and 19, the same processes as those according to the first or the second embodiments are performed for each of the data type (steps S1 to S5, or steps S1 to S5a).

As shown in Figs. 16 and 18, each of the data types has a priority. In other words, a different level of Quality of Service (QoS) is requested for each of the data types. The data types with higher priorities are assigned sequentially to the radio resource blocks with the higher channel qualities, and transmitted.

Moreover, as shown in Figs. 17 and 19, for example, if each of a data type #1 and a data type #2 respectively use two of the radio resources, and has the same QoS, the bit stream with the higher column-degree in each of the data types is assigned to a radio resource block with a higher channel quality, and transmitted.

As explained above, according to the sixth embodiment, the digital modulator 2 according to one of the first to the fifth embodiments is provided to each of the data types. In this manner, it is possible to achieve the same effects as those according to each of the embodiments described above when a plurality of data types are transmitted.

Seventh Embodiment

A communication method according to a seventh embodiment of the present invention will be now explained. According to the first to the sixth embodiments, the LDPC coding is used as a channel coding that uses a parity check matrix having uneven column-degrees (hereinafter, simply referred to as "check matrix"). Alternatively, in the explanation of the seventh embodiment, a channel coding can be converted into a check matrix having uneven column-degrees and arranged in the descending order of the column-degrees. In the seventh embodiment, only portions of the coding that are different from those of the first to the sixth embodiments will be explained.

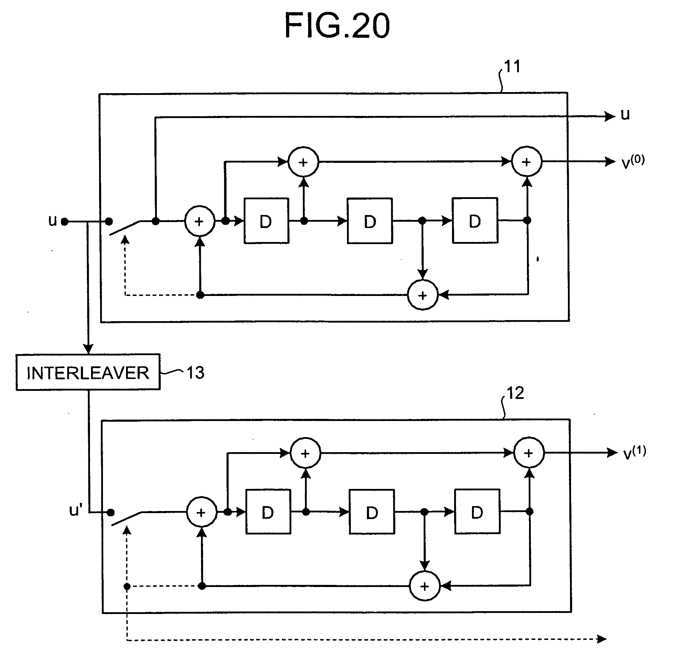

Fig. 20 is a schematic diagram of an encoder used for turbo coding according to the Release-6 of the 3rd Generation Partnership Project (3GPP) standard, which is one of standards for the third generation cellular phone. This turbo coding includes two recursive systematic convolutional (RSC) encoders 11, 12, and an interleaver 13.

It is assumed herein that information sequence u can be expressed as a formula (1) below, and sequences output from the two RSC encoders 11 and 12 are expressed as formulas (2) and (3), respectively.

$$u = (u_0, u_1, u_2, \ldots)$$
$$u_i \in \{0, 1\} \qquad\qquad (1)$$

[Formula 1]

$$v^{(0)} = \left( v_0^{(0)}, v_1^{(0)}, v_2^{(0)}, \cdots \right)$$
$$v_i^{(0)} \in \{0, 1\} \qquad\qquad (2)$$

[Formula 2]

$$v^{(1)} = \left( v_0^{(1)}, v_1^{(1)}, v_2^{(1)}, \cdots \right)$$

$$v_i^{(1)} \in \{0,1\} \tag{3}$$

Generating sequences can be expressed as a number of memory m (memories are denoted as D in Fig. 20, and m=3) +1. For example, two generating sequences of the RSC encoder 11 can be expressed as formulas (4) and (5) below. The RSC encoder 12 also has the same structure.

[Formula 3]

$$g^{(0)} = \left( g_0^{(0)}, g_1^{(0)}, \cdots, g_m^{(0)} \right)$$

$$g_i^{(0)} \in \{0,1\} \tag{4}$$

[Formula 4]

$$g^{(1)} = \left( g_0^{(1)}, g_1^{(1)}, \cdots, g_m^{(1)} \right)$$

$$g_i^{(1)} \in \{0,1\} \tag{5}$$

Therefore, the generating sequences for the RSC encoder 11 shown in Fig. 20 are expressed as formulas (6) and (7) below:

$$g^{(0)} = (1,1,0,1) \tag{6}$$

$$g^{(1)} = (1,0,1,1) \tag{7}$$

If the above generating sequences are expressed as generating polynomials, then the generating sequences can be expressed as formulas (8) and (9) blow:

$$g^{(0)}(D) = 1 + D + D^3 \tag{8}$$

$$g^{(1)}(D) = 1 + D^2 + D^3 \tag{9}$$

where, D is a delay element.
Therefore, the RSC encoder 11 shown in Fig. 20 can be expressed as a formula (10) below. (The same applies for the RSC encoder 12.)

[Formula 5]

$$G(D) = \left( 1 \quad \frac{1 + D + D^3}{1 + D^2 + D^3} \right) \tag{10}$$

Assuming that the check matrix is expressed as a polynomial H(D), then the check matrix H(D) corresponding to G(D) must satisfy the condition specified by a formula (11) below:

$$G(D) H^T(D) = 0 \qquad (11)$$

where, $H^T(D)$ is a transposed matrix of the matrix H(D). Therefore, a following formula (12) can be obtained.

[Formula 6]

$$H(D) = \left( \frac{1 + D + D^3}{1 + D^2 + D^3} \quad 1 \right) \qquad (12)$$

The matrix expressed in the formula (12) can be converted into a formula (13) below by multiplying $1+D^2+D^3$.

$$H'(D) = (1+D+D^3 \quad 1+D^2+D^3) \qquad (13)$$

The H'(D) in the formula (13) that is converted into to a binary {0,1} matrix can be expressed as a formula (14) below.

[Formula 7]

$$H' = \begin{bmatrix} 1 & 1 & & & & & & & & & \\ 1 & 0 & 1 & 1 & & & & & & & \\ 0 & 1 & 1 & 0 & 1 & 1 & & & & & \\ 1 & 1 & 0 & 1 & 1 & 0 & 1 & 1 & & & \\ & 1 & 1 & 0 & 1 & 1 & 0 & 1 & 1 & & \\ & & 1 & 1 & 0 & 1 & 1 & 0 & 1 & 1 & \\ & & & 1 & 1 & 0 & 1 & 1 & 0 & 1 & 1 \\ & & & & 1 & 1 & 0 & 1 & 1 & 0 & \\ & & & & & 1 & 1 & 0 & 1 & & \\ & & & & & & 1 & 1 & & & \end{bmatrix} \qquad (14)$$

A code word $C_1$ corresponding to the RSC encoder 11 can be expressed as a formula (15) below, where k is a length of the information.

[Formula 8]

$$c_1 = \left( u_0 v_0^{(0)}, u_1 v_1^{(0)}, \cdots, u_k v_k^{(0)} \right) \qquad (15)$$

If a column replacement is performed to H' above, then a formula (16) below is established.
[Formula 9]

$$
H'' = \begin{bmatrix}
1 & & & & & & 1 & & & & & & & & \\
1 & 1 & & & & & 0 & 1 & & & & & & & \\
0 & 1 & 1 & & & & 1 & 0 & 1 & & & & & & \\
1 & 0 & 1 & 1 & & & 1 & 1 & 0 & 1 & & & & & \\
& 1 & 0 & 1 & 1 & & & 1 & 1 & 0 & 1 & & & & \\
& & 1 & 0 & 1 & 1 & & & 1 & 1 & 0 & 1 & & & \\
& & & 1 & 0 & 1 & 1 & & & 1 & 1 & 0 & 1 & & \\
& & & & 1 & 0 & 1 & & & & 1 & 1 & 0 & & \\
& & & & & 1 & 0 & & & & & 1 & 1 & & \\
& & & & & & 1 & & & & & & 1 & &
\end{bmatrix}
\qquad (16)
$$

Therefore, the corresponding code word $C_1'$ will be as expressed in a formula (17) shown below, and result in a sequence that is equivalent to the systematic code of the ordinary LDPC codes.

[Formula 10]

$$
c'_1 = \left( u_0, u_1, \cdots, u_k, v_0^{(0)}, v_1^{(0)}, \cdots, v_k^{(0)} \right) \qquad (17)
$$

Furthermore, the RSC encoder 12 also performs coding via the interleaver 13. In other words, an information portion is interleaved to generate parity by following the same operations as described above.
Therefore, the uneven parity check matrix $H_{full}''$ obtained according to the present embodiment can be converted as a formula (18) shown below.

[Formula 11]

$$H_{full}'' = \begin{bmatrix} 1 & & & & & 1 & & & & & & & & & & \\ 1 & 1 & & & & 0 & 1 & & & & & & & & & \\ 0 & 1 & 1 & & & 1 & 0 & 1 & & & & & & & & \\ 1 & 0 & 1 & 1 & & 1 & 1 & 0 & 1 & & & & & & & \\ & 1 & 0 & 1 & 1 & & 1 & 1 & 0 & 1 & & & & & & \\ & & 1 & 0 & 1 & 1 & & 1 & 1 & 0 & 1 & & & & & \\ & & & 1 & 0 & 1 & 1 & & 1 & 1 & 0 & 1 & & & & \\ & & & & 1 & 0 & 1 & & & 1 & 1 & 0 & & & & \\ & & & & & 1 & 0 & & & & 1 & 1 & & & & \\ & & & & & 1 & & & & & & 1 & & & & \\ 1 & & & & & & & & 1 & & & & & & & \\ 1 & 1 & & & & & & & 0 & 1 & & & & & & \\ 1 & 0 & & 1 & & & & & 1 & 0 & 1 & & & & & \\ 1 & 1 & & 0 & 1 & & & & 1 & 1 & 0 & 1 & & & & \\ 0 & & 1 & 1 & & 1 & & & & 1 & 1 & 0 & 1 & & & \\ 1 & & & 0 & 1 & 1 & & & & & 1 & 1 & 0 & 1 & & \\ & 1 & & 1 & 1 & 0 & & & & & & 1 & 1 & 0 & 1 & \\ & 1 & & & 0 & 1 & & & & & & & 1 & 1 & 0 & \\ & 0 & & & 1 & & & & & & & & & 1 & 1 & \\ & 1 & & & & & & & & & & & & & 1 & \end{bmatrix} \quad (18)$$

Here, the matrix can be converted to an uneven parity check matrix having column-degrees of 6 and 3.

The code word corresponding to this will be as shown in a formula (19), and a turbo code with coding ratio of 1/3 can be replaced with the parity check matrix $H_{full}''$.

[Formula 12]

$$\mathbf{c}'_{full} = \left( u_0, u_1, \cdots, u_k, v_0^{(0)}, v_1^{(0)}, \cdots, v_k^{(0)}, v_0^{(1)}, v_1^{(1)}, \cdots, v_k^{(1)} \right) \quad (19)$$

It can be seen that the parity check matrix shown in formula (18) has an uneven column-degree distribution, in the same manner as that shown in Fig. 4. According to the seventh embodiment, a code word is generated using this check matrix, and the code word is segmented into a plurality of data streams, and a segmented data stream having most bits corresponding to a column with the largest column-degree in the parity check matrix is assigned to a radio resource block with a higher channel quality, in the same manner as in the first to the sixth embodiments. In other words, the data stream with a higher reliability is transmitted with a radio resource block having a higher channel quality. Therefore, the system performance and the system capacity can be improved, in comparison with a known technology.

According to the seventh embodiment, the turbo coding used in the 3GPP is used as an example in the explanation. However, the conversion may be applied to most of the error-correcting codes/channel coding methods. In other words, as long as the parity check matrix after conversion has uneven column-degrees, the communication method according to the seventh embodiment can be applied in the same manner.

INDUSTRIAL APPLICABILITY

As described above, the communication method according to the present invention is useful in a radio communication system implemented with a multi-carrier modulation scheme, and especially useful in a communication apparatus that assigns radio resources by taking advantage of the characteristics of the LDPC coding.

**Claims**

1. A communication method that performs low density parity check (LDPC) coding to a data stream to be transmitted in a radio communication system by using a parity check matrix that has columns with uneven column degrees, the columns arranged in a descending order of the column degrees, the communication method comprising:

   segmenting a code word into a plurality of data streams depending on number of data bits that are assignable to a radio resource block that is a unit of radio transmission; and
   assigning a segmented data stream having a higher column degree to a radio resource block with higher quality.

2. The communication method according to claim 1, wherein the quality is channel quality measured by a communication apparatus to which communication is established.

3. The communication method according to claim 1, wherein the radio resource block with higher quality is a radio resource block located at a position near center of a radio frequency range available in the system.

4. The communication method according to claim 1, wherein, upon allocating data symbols to the radio resource blocks, a data symbol with a higher column degree is allocated to a position near a known quality-measuring signal.

5. The communication method according to claim 1, wherein, upon allocating data symbols to the radio resource blocks, a data symbol with a higher column degree is allocated to a position near center of the radio resource block.

6. The communication method according to claim 1, wherein, upon allocating data symbols to the radio resource blocks, a data symbol with a higher column degree is allocated to a position near center of the radio resource blocks in a time direction.

7. The communication method according to claim 1, wherein, upon allocating data symbols to the radio resource blocks, a data symbol with a higher column degree is allocated to a position near center of the radio resource blocks in a frequency direction.

8. The communication methods according to any one of claims 1 to 7, wherein
   upon transmitting a plurality of transmitted data types, the segmenting and the assigning are performed individually for each of the data types.

9. The communication method according to claim 8, wherein if the data types have different QoS levels, a transmitted data type with a higher priority is assigned to a radio resource block with higher quality.

10. The communication method according to claim 8, wherein if the data types have an equal QoS level, a data stream with a higher column degree in each type is assigned to a radio resource block with higher quality.

11. A communication method that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near a known quality-measuring signal.

12. A communication method that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks.

13. A communication method that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks in a time direction.

14. A communication method that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks in a frequency direction.

15. A communication apparatus that performs low density parity check (LDPC) coding to a data stream to be transmitted in a radio communication system by using a parity check matrix having columns with uneven column degrees, the columns arranged in a descending order of the column degrees, the communication apparatus comprising:

   a scheduling unit that assigns radio resources; and
   a radio resource assigning unit that segments a code word into a plurality of data streams based on number of data bits, received from the scheduling unit, that are assignable to a radio resource block that is a unit of radio transmission, and assigns a segmented data stream with a higher column degree to a radio resource block with higher quality.

16. The communication apparatus according to claim 15, wherein the quality is channel quality measured by a communication apparatus to which communication is established.

17. The communication apparatus according to claim 15, wherein the radio resource block with higher quality is a radio resource block located at a position near center of a radio frequency range available in the system.

18. The communication apparatus according to claim 15, wherein, upon allocating data symbols to the radio resource blocks, the radio resource assigning unit allocates a data symbol with a higher column degree to a position near a known quality-measuring signal.

19. The communication apparatus according to claim 15, wherein, upon allocating data symbols to the radio resource blocks, the radio resource assigning unit allocates a data symbol with a higher column degree to a position near center of the radio resource block.

20. The communication apparatus according to claim 15, wherein, upon allocating data symbols to the radio resource blocks, the radio resource assigning unit allocates a data symbol with a higher column degree to a position near center of the radio resource blocks in a time direction.

21. The communication apparatus according to claim 15, wherein, upon allocating data symbols to the radio resource blocks, the radio resource assigning unit allocates a data symbol with a higher column degree to a position near center of the radio resource blocks in a frequency direction.

22. The communication apparatus according to any one of claims 15 to 21, wherein
   the radio resource assigning unit is provided in plurality corresponding to the transmitted data types, and
   the radio resource assigning unit operates individually for each of the data types.

23. The communication apparatus according to claim 22, wherein if the data types have different QoS levels, a transmitted data type with a higher priority is assigned to a radio resource block with higher quality.

24. The communication apparatus according to claim 22,
   wherein if the data types have an equal QoS level, a data stream with a higher column degree in each type is assigned to a radio resource block with higher quality.

25. A communication apparatus that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near a known quality-measuring signal.

26. A communication apparatus that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks.

27. A communication apparatus that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks in a time direction.

28. A communication apparatus that performs low density parity check (LDPC) coding to a data stream to be transmitted in a radio communication system by using a parity check matrix having columns with uneven column degrees, the columns arranged in a descending order of the column degrees, wherein, upon allocating data symbols to radio resource blocks, a data symbol with a higher column degree is allocated to a position near center of the radio resource blocks in a frequency direction.

29. A communication method that performs coding to a data stream to be transmitted in a radio communication system implemented with a multi-carrier modulation method, by using channel coding that provides data conversion into a parity check matrix having columns with uneven column degrees, the columns arranged in a descending order of the column degrees, the communication method comprising:

segmenting a code word into a plurality of data streams depending on number of data bits that are assignable to a radio resource block that is a unit of radio transmission; and
assigning a segmented data stream having a higher column degree to a radio resource block with higher quality.

30. The communication method according to claim 29, wherein the quality is channel quality measured by a communication apparatus to which communication is established.

31. The communication method according to claim 29,
wherein the radio resource block with higher quality is a radio resource block located at a position near center of a radio frequency range available in the system.

32. The communication method according to claim 29, wherein, upon allocating data symbols to the radio resource blocks, a data symbol with a higher column degree is allocated to a position near a known quality-measuring signal.

33. The communication method according to claim 29, wherein, upon allocating data symbols to the radio resource blocks, a data symbol with a higher column degree is allocated to a position near center of the radio resource block.

34. The communication method according to claim 29, wherein, upon allocating data symbols to the radio resource blocks, a data symbol with a higher column degree is allocated to a position near center of the radio resource blocks in a time direction.

35. The communication method according to claim 29, wherein, upon allocating data symbols to the radio resource blocks, a data symbol with a higher column degree is allocated to a position near center of the radio resource blocks in a frequency direction

36. The communication methods according to any one of claims 29 to 35, wherein upon transmitting a plurality of transmitted data types, the segmenting and the assigning are performed individually for each of the data types.

37. The communication method according to claim 36, wherein if the data types have different QoS levels, a transmitted data type with a higher priority is assigned to a radio resource block with higher quality.

38. The communication method according to claim 36, wherein if the data types have an equal QoS level, a data stream with a higher column degree in each type is assigned to a radio resource block with higher quality.

39. A communication apparatus that performs coding to a data stream to be transmitted in a radio communication system implemented with a multi-carrier modulation method, by using channel coding that provides data conversion into a parity check matrix having columns with uneven column degrees, the columns arranged in a descending order of the column degrees, the communication apparatus comprising:

a scheduling unit that assigns radio resources; and

a radio resource assigning unit that segments a code word into a plurality of data streams based on number of data bits, received from the scheduling unit, that are assignable to a radio resource block that is a unit of radio transmission, and assigns a segmented data stream with a higher column degree to a radio resource block with higher quality.

40. The communication apparatus according to claim 39, wherein the quality is channel quality measured by a communication apparatus to which communication is established.

41. The communication apparatus according to claim 39, wherein the radio resource block with higher quality is a radio resource block located at a position near center of a radio frequency range available in the system.

42. The communication apparatus according to claim 39, wherein, upon allocating data symbols to the radio resource blocks, the radio resource assigning unit allocates a data symbol with a higher column degree to a position near a known quality-measuring signal.

43. The communication apparatus according to claim 39, wherein, upon allocating data symbols to the radio resource blocks, the radio resource assigning unit allocates a data symbol with a higher column degree to a position near center of the radio resource block.

44. The communication apparatus according to claim 39, wherein, upon allocating data symbols to the radio resource blocks, the radio resource assigning unit allocates a data symbol with a higher column degree to a position near center of the radio resource blocks in a time direction.

45. The communication apparatus according to claim 39, wherein, upon allocating data symbols to the radio resource blocks, the radio resource assigning unit allocates a data symbol with a higher column degree to a position near center of the radio resource blocks in a frequency direction.

46. The communication apparatus according to any one of claims 39 to 45, wherein
the radio resource assigning unit is provided in plurality corresponding to the transmitted data types, and
the radio resource assigning unit operates individually for each of the data types.

47. The communication apparatus according to claim 46, wherein if the data types have different QoS levels, a transmitted data type with a higher priority is assigned to a radio resource block with higher quality.

48. The communication apparatus according to claim 46,
wherein if the data types have an equal QoS level, a data stream with a higher column degree in each type is assigned to a radio resource block with higher quality.

# FIG.1

RADIO RESOURCE DEMANDS, QoSs →

MEASURED TX CHANNEL QUALITIES (CQIs) →

Ack/Ncks →

RADIO RESOURCE SCHEDULER &1

TO THE OTHER TRANSMITTERS

L2 PDU → CRC BITS GENERATOR / ATTACHER &3 → CHANNEL ENCODER &4 → HARQ PROC-ESSOR &5 → DATA BIT STREAM SPLITTER &6 → ADAPTIVE MODULATOR (S) &7 → TO RF TX PART

&2

EP 1 959 598 A1

# FIG.2

L2 PDU

↓

| CRC ATTACHMENT | ~ S1 |

↓

| CHANNEL CODING | ~ S2 |

↓

| HARQ FUNCTIONALITY INCLUDING ADAPTIVE CODING RATE | ~ S3 |

↓

| COLUMN-DEGREE BASED PHYSICAL CHANNEL SEGMENTATION (RESOURCE BLOCK MAPPING) | ~ S4 |

COLUMN DEGREE

HIGHER ←——————→ LOWER

| ADAPTIVE MODULATION (A COMMON MODULATION IS SELECTED) | ~ S5 |

CHANNEL QUALITY

BETTER ←——————→ WORSE

TO ASSIGNED RESOURCE BLOCK     TO ASSIGNED RESOURCE BLOCK     TO ASSIGNED RESOURCE BLOCK

# FIG.3-1

20 TO 1.25 MHz

(a)

Amp.

$f_1$ $f_2$ $f_3$ ··· ··· $f_{N-2}$ $f_{N-1}$ $f_N$

(b)

| #1 | #2 ··· #M-1 | #M |

f

# FIG.3-2

$t_1$

$t_2$

$t_3$

$t_5$

(c)

| #1($t_1$) | #2($t_1$) | #3($t_1$) | #4($t_1$) | #5($t_1$) | #6($t_1$) | #7($t_1$) | #8($t_1$) |
| #1($t_2$) | #2($t_2$) | #3($t_2$) | #4($t_2$) | #5($t_2$) | #6($t_2$) | #7($t_2$) | #8($t_2$) |
| #1($t_3$) | #2($t_3$) | #3($t_3$) | #4($t_3$) | #5($t_3$) | #6($t_3$) | #7($t_3$) | #8($t_3$) |
| #1($t_4$) | #2($t_4$) | #3($t_4$) | #4($t_4$) | #5($t_4$) | #6($t_4$) | #7($t_4$) | #8($t_4$) |

$t$

(d)

C/I

@UE A

f

(e)

C/I

@UE A

#1    #2    #3    #4    #5    #6    #7    #8

f

$t_k$

(f)

| | UE A COL-UMN-DEGREE HIGHER | | UE A COL-UMN-DEGREE LOWER | | | | |

$t$

# FIG.4

$$
\begin{array}{c}
\overbrace{\hspace{3cm}}^{\text{COLUMN-}}\overbrace{\hspace{3cm}}^{\text{COLUMN-}} \\
\text{DEGREE=3} \quad \text{DEGREE=2}
\end{array}
$$

$$
H = \left[\left(\begin{array}{cccccc}
1 & 0 & 1 & 1 & 0 & 0 \\
0 & 0 & 1 & 1 & 1 & 0 \\
1 & 1 & 0 & 0 & 0 & 1 \\
0 & 1 & 0 & 1 & 1 & 0 \\
1 & 1 & 0 & 0 & 0 & 1 \\
0 & 0 & 1 & 0 & 1 & 1
\end{array}\right)\left(\begin{array}{cccccc}
1 & 0 & 0 & 0 & 0 & 0 \\
1 & 1 & 0 & 0 & 0 & 0 \\
0 & 1 & 1 & 0 & 0 & 0 \\
0 & 0 & 1 & 1 & 0 & 0 \\
0 & 0 & 0 & 1 & 1 & 0 \\
0 & 0 & 0 & 0 & 1 & 1
\end{array}\right)\right]
$$

$$
C = \left[\begin{array}{cccccc|cccccc}
1 & 0 & 0 & 1 & 0 & 0 & 0 & 1 & 0 & 1 & 0 & 0
\end{array}\right]
$$

$$
\underbrace{\hspace{3cm}}_{\substack{= \\ \text{HIGHER}}} \quad \underbrace{\hspace{3cm}}_{\substack{= \\ \text{LOWER}}}
$$

# FIG.5

| NODE B / BASE STATION | UE / MOBILE TERMINAL |
|---|---|

S11

TRANSMIT PILOT /
FIRST REFERENCE SYMBOL
(S)

S12

MEASUREMENT OF THE
DOWNLINK CHANNEL
QUALITY

S14

COLLECT THE RADIO
RESOURCE DEMANDS ON
DOWNLINK

S13

REPORT THE MEASURED
DOWNLINK CHANNEL
QUALITY VIA UPLINK

S15

COLLECT THE MEASURED
DOWNLINK CHANNEL
QUALITY
REPORTS FROM
ACTIVE UE (S)

S16

ALLOCATE RADIO
RESOURCE TO EACH UE ON
DOWNLINK TRANSMISSION

S17

DECIDE ON MODULATION
SCHEME AND CHANNEL
CODING RATE FOR
EACH UE

S18

CHANNEL CODING FOR EACH
UE, BASED ON THE
COLUMN-DEGREE OBTAINED
FROM THE RESULT OF ITS
CHANNEL CODING PROCESS

S19

ADAPTIVE MODULATION /
DOWNLINK TRANSMISSION
ON EACH RESOURCE BLOCK

S20

RECEIVE THE
TRANSMITTED SYMBOLS ON
DOWNLINK

# FIG.6

SYSTEM BANDWIDTH

ASSIGNED BANDWIDTH

$C/I$

@UE A

(a)

$f$

$C/I$

@UE A

(b)

#1    #2    #3    #4    #5    #6    #7    #8

$f$

$t_k$

$f$

(c)

| | | | | UE A COL- UMN- DEGREE HIGHER | | UE A COL- UMN- DEGREE LOWER | |

$t$

# FIG.7

L2 PDU

↓

| CRC ATTACHMENT | ~S1 |

↓

| CHANNEL CODING | ~S2 |

↓

| HARQ FUNCTIONALITY INCLUDING ADAPTIVE CODING RATE | ~S3 |

↓

| COLUMN-DEGREE BASED PHYSICAL CHANNEL SEGMENTATION (RESOURCE BLOCK MAPPING) | ~S4a |

COLUMN DEGREE

HIGHER ⟷ LOWER

| ADAPTIVE MOD-ULATION | ADAPTIVE MOD-ULATION | ··· | ADAPTIVE MOD-ULATION | ~S5a |

S5a

S5a

CHANNEL QUALITY

BETTER ⟷ WORSE

TO ASSIGNED RESOURCE BLOCK | TO ASSIGNED RESOURCE BLOCK | TO ASSIGNED RESOURCE BLOCK

# FIG.8

# FIG.9

L2 PDU

↓

| CRC ATTACHMENT | ~S1 |

↓

| CHANNEL CODING | ~S2 |

↓

| HARQ FUNCTIONALITY INCLUDING ADAPTIVE CODING RATE | ~S3 |

↓

| COLUMN-DEGREE BASED PHYSICAL CHANNEL SEGMENTATION (RESOURCE BLOCK MAPPING) | ~S4b |

COLUMN DEGREE

HIGHER ⟵⟶ LOWER

| ADAPTIVE MODULATION (A COMMON MODULATION IS SELECTED) | ~S5 |

RESOURCE BLOCK LOCATION

NEARER TO THE CENTER ⟵⟶ FARTHER FROM THE CENTER

TO ASSIGNED RESOURCE BLOCK    TO ASSIGNED RESOURCE BLOCK    TO ASSIGNED RESOURCE BLOCK

# FIG.10

# FIG.11

L2 PDU

↓

| CRC ATTACHMENT | ~ S1 |

↓

| CHANNEL CODING | ~ S2 |

↓

| HARQ FUNCTIONALITY INCLUDING ADAPTIVE CODING RATE | ~ S3 |

↓

| COLUMN-DEGREE BASED PHYSICAL CHANNEL SEGMENTATION (RESOURCE BLOCK MAPPING) | ~ S4c |

HIGHER ⟺ COLUMN DEGREE ⟺ LOWER

| ADAPTIVE MOD-ULATION | ADAPTIVE MOD-ULATION | ... | ADAPTIVE MOD-ULATION | ~ S5a |
S5a | S5a

NEARER TO THE CENTER ⟺ RESOURCE BLOCK LOCATION ⟺ FARTHER FROM THE CENTER

TO ASSIGNED RESOURCE BLOCK | TO ASSIGNED RESOURCE BLOCK | TO ASSIGNED RESOURCE BLOCK

# FIG.12-1

(a)

| #1 | #2 | #3 | #4 | #5 | #6 | #7 | #8 | → $f$ |

$t$ ↓

(b)

|  | $f_1$ | $f_2$ | $f_3$ | $f_4$ | $f_5$ | $f_6$ | $f_7$ | $f_8$ |
|---|---|---|---|---|---|---|---|---|
| $t_1$ | $D$ | $D$ | $D$ | $D$ | $D$ | $D$ | $D$ | $D$ |
| $t_2$ | $R_1$ | $D$ | $R_1$ | $D$ | $R_1$ | $D$ | $R_1$ | $D$ |
| $t_3$ | $D$ | $D$ | $D$ | $D$ | $D$ | $D$ | $D$ | $D$ |
| $t_4$ | $D$ | $D$ | $D$ | $D$ | $D$ | $D$ | $D$ | $D$ |
| $t_5$ | $D$ | $D$ | $D$ | $D$ | $D$ | $D$ | $D$ | $D$ |
| $t_6$ | $D$ | $D$ | $D$ | $D$ | $D$ | $D$ | $D$ | $D$ |
| $t_7$ | $D$ | $R_2$ | $D$ | $R_2$ | $D$ | $R_2$ | $D$ | $R_2$ |
| $t_8$ | $D$ | $D$ | $D$ | $D$ | $D$ | $D$ | $D$ | $D$ |

# FIG.12-2

|  | $f_1$ | $f_2$ | $f_3$ | $f_4$ | $f_5$ | $f_6$ | $f_7$ | $f_8$ |
|---|---|---|---|---|---|---|---|---|
| $t_1$ | | | | | | | | |
| $t_2$ | | | FOR HIGHER COLUMN-DEGREE SYMBOLS | | | | | |
| $t_3$ | | | | | | | | |
| $t_4$ | | | | | | | | |
| $t_5$ | | | | | | | | |
| $t_6$ | | | FOR LOWER COLUMN-DEGREE SYMBOLS | | | | | |
| $t_7$ | | | | | | | | |
| $t_8$ | | | | | | | | |

# FIG.12-3

|  | $f_1$ | $f_2$ | $f_3$ | $f_4$ | $f_5$ | $f_6$ | $f_7$ | $f_8$ |
|---|---|---|---|---|---|---|---|---|

$t_1$
$t_2$
$t_3$

FOR HIGHER COLUMN-DEGREE SYMBOLS

$t_4$
$t_5$

FOR LOWER COLUMN-DEGREE SYMBOLS

$t_6$
$t_7$
$t_8$

FOR HIGHER COLUMN-DEGREE SYMBOLS

# FIG.12-4

|  | $f_1$ | $f_2$ | $f_3$ | $f_4$ | $f_5$ | $f_6$ | $f_7$ | $f_8$ |
|---|---|---|---|---|---|---|---|---|

$t_1$
$t_2$
$t_3$
$t_4$
$t_5$
$t_6$
$t_7$
$t_8$

FOR LOWER COLUMN-DEGREE SYMBOLS

FOR HIGHER COLUMN-DEGREE SYMBOLS

# FIG.12-5

# FIG.12-6

# FIG.13

L2 PDU

↓

| CRC ATTACHMENT | ~ S1 |

↓

| CHANNEL CODING | ~ S2 |

↓

| HARQ FUNCTIONALITY INCLUDING ADAPTIVE CODING RATE | ~ S3 |

↓

| COLUMN-DEGREE BASED PHYSICAL CHANNEL SEGMENTATION (RESOURCE BLOCK MAPPING) | ~ S4 |

↓

| COLUMN-DEGREE BASED SYMBOL MAPPING ~S31 | COLUMN-DEGREE BASED SYMBOL MAPPING ~S31 | COLUMN-DEGREE BASED SYMBOL MAPPING ~S31 |

↓

| ADAPTIVE MODULATION (A COMMON MODULATION IS SELECTED) | ~ S5 |

↓

TO ASSIGNED RESOURCE BLOCK      TO ASSIGNED RESOURCE BLOCK      TO ASSIGNED RESOURCE BLOCK

# FIG.14

L2 PDU

↓

CRC ATTACHMENT  ～S1

↓

CHANNEL CODING  ～S2

↓

HARQ FUNCTIONALITY INCLUDING ADAPTIVE CODING RATE  ～S3

↓

COLUMN-DEGREE BASED PHYSICAL CHANNEL SEGMENTATION (RESOURCE BLOCK MAPPING)  ～S4

| COLUMN-DEGREE BASED SYMBOL MAPPING ～S31 | COLUMN-DEGREE BASED SYMBOL MAPPING ～S31 | COLUMN-DEGREE BASED SYMBOL MAPPING ～S31 |
|---|---|---|
| ADAPTIVE MOD-ULATION ～S5a | ADAPTIVE MOD-ULATION ～S5a | ADAPTIVE MOD-ULATION ～S5a |
| TO ASSIGNED RESOURCE BLOCK | TO ASSIGNED RESOURCE BLOCK | TO ASSIGNED RESOURCE BLOCK |

# FIG.15

RADIO RESOURCE DEMANDS, QoSs

MEASURED TX CHANNEL QUALITIES (CQIs)

Ack/Ncks

TO THE OTHER TRANSMITTERS

RADIO RESOURCE SCHED-ULER

1a

m

m

m

m

2a

L2 PDU #1

3a-1 CRC BITS GENERATOR / ATTACHER #1

4a-1 CHANNEL ENCODER #1

5a-1 HARQ PROC-ESSOR #1

6a-1 DATA BIT STREAM SPLITTER #1

7a-1 ADAPTIVE MODULATOR (S) #1

L2 PDU #m

3a-m CRC BITS GENERATOR / ATTACHER #m

4a-m CHANNEL ENCODER #m

5a-m HARQ PROC-ESSOR #m

6a-m DATA BIT STREAM SPLITTER #m

7a-m ADAPTIVE MODULATOR (S) #m

TO RF TX PART

EP 1 959 598 A1

35

# FIG.16

DATA STREAM #1                    DATA STREAM #2

| CRC ATTACHMENT #1 | S1 |
CHANNEL CODING #1 — S2

HARQ FUNCTIONALITY INCLUDING ADAPTIVE CODING RATE #1 — S3

S4
COLUMN-DEGREE BASED PHYSICAL CHANNEL SEGMENTATION #1 (RESOURCE BLOCK MAPPING)

HIGHER  COLUMN DEGREE  LOWER

S5
ADAPTIVE MODULATION #1 (A COMMON MODULATION IS SELECTED)

BETTER    CHANNEL QUALITY    WORSE

TO ASSIGNED RESOURCE BLOCK   TO ASSIGNED RESOURCE BLOCK

CRC ATTACHMENT #2 — S1
CHANNEL CODING #2 — S2

HARQ FUNCTIONALITY INCLUDING ADAPTIVE CODING RATE #2 — S3

COLUMN-DEGREE BASED PHYSICAL CHANNEL SEGMENTATION #2 (RESOURCE BLOCK MAPPING) — S4

HIGHER  COLUMN DEGREE  LOWER

ADAPTIVE MODULATION #2 (A COMMON MODULATION IS SELECTED) — S5

TO ASSIGNED RESOURCE BLOCK   TO ASSIGNED RESOURCE BLOCK

# FIG.17

DATA STREAM #1

DATA STREAM #2

| | |
|---|---|
| CRC ATTACHMENT #1 ⌇S1 | CRC ATTACHMENT #2 ⌇S1 |
| CHANNEL CODING #1 ⌇S2 | CHANNEL CODING #2 ⌇S2 |
| HARQ FUNCTIONALITY INCLUDING ADAPTIVE CODING RATE #1 ⌇S3 | HARQ FUNCTIONALITY INCLUDING ADAPTIVE CODING RATE #2 ⌇S3 |
| COLUMN-DEGREE BASED PHYSICAL CHANNEL SEGMENTATION #1 (RESOURCE BLOCK MAPPING) S4 | COLUMN-DEGREE BASED PHYSICAL CHANNEL SEGMENTATION #2 (RESOURCE BLOCK MAPPING) S4 |

HIGHER  COLUMN DEGREE  LOWER  HIGHER  COLUMN DEGREE  LOWER

S5  S5

| | |
|---|---|
| ADAPTIVE MODULATION #1 (A COMMON MODULATION IS SELECTED) | ADAPTIVE MODULATION #2 (A COMMON MODULATION IS SELECTED) |

CHANNEL QUALITY

BETTER ⟵⟶ WORSE

TO ASSIGNED RESOURCE BLOCK

TO ASSIGNED RESOURCE BLOCK

TO ASSIGNED RESOURCE BLOCK

TO ASSIGNED RESOURCE BLOCK

# FIG.18

DATA STREAM #1                                    DATA STREAM #2

| CRC ATTACHMENT #1 | S1 |
| CRC ATTACHMENT #2 | S1 |

| CHANNEL CODING #1 | S2 |
| CHANNEL CODING #2 | S2 |

| HARQ FUNCTIONALITY INCLUDING ADAPTIVE CODING RATE #1 | S3 |
| HARQ FUNCTIONALITY INCLUDING ADAPTIVE CODING RATE #2 | S3 |

S4a

| COLUMN-DEGREE BASED PHYSICAL CHANNEL SEGMENTATION #1 (RESOURCE BLOCK MAPPING) |
| COLUMN-DEGREE BASED PHYSICAL CHANNEL SEGMENTATION #2 (RESOURCE BLOCK MAPPING) |

COLUMN DEGREE

HIGHER ⟷ LOWER          HIGHER ⟷ LOWER

| ADAPTIVE MOD-ULATION | S5a |  ...  | ADAPTIVE MOD-ULATION | S5a |
| ADAPTIVE MOD-ULATION | S5a |  ...  | ADAPTIVE MOD-ULATION | S5a |

CHANNEL QUALITY

BETTER ⟷ WORSE

TO ASSIGNED RESOURCE BLOCK          TO ASSIGNED RESOURCE BLOCK          TO ASSIGNED RESOURCE BLOCK          TO ASSIGNED RESOURCE BLOCK

# FIG.19

DATA STREAM #1

DATA STREAM #2

| CRC ATTACHMENT #1 | ~S1 |

| CHANNEL CODING #1 | ~S2 |

| HARQ FUNCTIONALITY INCLUDING ADAPTIVE CODING RATE #1 | ~S3 |

| COLUMN-DEGREE BASED PHYSICAL CHANNEL SEGMENTATION #1 (RESOURCE BLOCK MAPPING) | S4a |

| CRC ATTACHMENT #2 | ~S1 |

| CHANNEL CODING #2 | ~S2 |

| HARQ FUNCTIONALITY INCLUDING ADAPTIVE CODING RATE #2 | ~S3 |

| COLUMN-DEGREE BASED PHYSICAL CHANNEL SEGMENTATION #2 (RESOURCE BLOCK MAPPING) | S4a |

COLUMN DEGREE

HIGHER          LOWER          HIGHER          LOWER

| ADAPTIVE MOD-ULATION | S5a | ... | ADAPTIVE MOD-ULATION | S5a | ADAPTIVE MOD-ULATION | S5a | ... | ADAPTIVE MOD-ULATION | S5a |

CHANNEL QUALITY

BETTER                                          WORSE

TO ASSIGNED RESOURCE BLOCK

TO ASSIGNED RESOURCE BLOCK

TO ASSIGNED RESOURCE BLOCK

TO ASSIGNED RESOURCE BLOCK

# FIG.20

## INTERNATIONAL SEARCH REPORT

| | International application No. |
|---|---|
| | PCT/JP2006/324540 |

A. CLASSIFICATION OF SUBJECT MATTER
*H04J1/00*(2006.01)i, *H03M13/19*(2006.01)i, *H04J3/00*(2006.01)i, *H04J11/00*
(2006.01)i, *H04L1/00*(2006.01)i, *H04Q7/36*(2006.01)i, *H04Q7/38*(2006.01)i

According to International Patent Classification (IPC) or to both national classification and IPC

B. FIELDS SEARCHED

Minimum documentation searched (classification system followed by classification symbols)
H04J1/00, H03M13/19, H04J3/00, H04J11/00, H04L1/00, H04Q7/36, H04Q7/38

Documentation searched other than minimum documentation to the extent that such documents are included in the fields searched
Jitsuyo Shinan Koho           1922-1996    Jitsuyo Shinan Toroku Koho    1996-2007
Kokai Jitsuyo Shinan Koho     1971-2007    Toroku Jitsuyo Shinan Koho    1994-2007

Electronic data base consulted during the international search (name of data base and, where practicable, search terms used)
IEEE

C. DOCUMENTS CONSIDERED TO BE RELEVANT

| Category* | Citation of document, with indication, where appropriate, of the relevant passages | Relevant to claim No. |
|---|---|---|
| P,X<br><br>P,A | Mitsubishi Electric, Ordered transmission scheme for LDPC-codedsymbols, 3GPP TSG RAN WG1 LTE Ad Hoc R1-061813, 2006.06, Internet <URL:http://www.3gpp.org/ftp/tsg_ran/WG1_RL1/ TSGR1_AH/LTE_AH_June-06/Docs/R1-061813.zip> | 1,2,15,16, 29,30,39,40<br>3-14,17-28, 31-38,41-48 |
| A | JP 2005-277784 A  (Toshiba Corp.), 06 October, 2005 (06.10.05), Claim 1; Figs. 13 to 16 & US 2005/0216821 A1    & CN 1674447 A | 1-48 |
| A | JP 2005-39585 A  (Tokyo University of Science), 10 February, 2005 (10.02.05), Claims 1 to 9 (Family: none) | 1-48 |

| ☒ Further documents are listed in the continuation of Box C. | ☐ See patent family annex. |
|---|---|

\*       Special categories of cited documents:
"A"     document defining the general state of the art which is not considered   to be of particular relevance
"E"     earlier application or patent but published on or after the international filing date
"L"     document which may throw doubts on priority claim(s) or which is cited to establish the publication date of another citation or other special reason (as specified)
"O"     document referring to an oral disclosure, use, exhibition or other means
"P"     document published prior to the international filing date but later than the priority date claimed

"T"     later document published after the international filing date or priority date and not in conflict with the application but cited to understand the principle or theory underlying the invention
"X"     document of particular relevance; the claimed invention cannot be considered novel or cannot be considered to involve an inventive step when the document is taken alone
"Y"     document of particular relevance; the claimed invention cannot be considered to involve an inventive step when the document is combined with one or more other such documents, such combination being obvious to a person skilled in the art
"&"     document member of the same patent family

| Date of the actual completion of the international search<br>    04 January, 2007 (04.01.07) | Date of mailing of the international search report<br>    16 January, 2007 (16.01.07) |
|---|---|
| Name and mailing address of the ISA/<br>    Japanese Patent Office | Authorized officer |
| Facsimile No. | Telephone No. |

Form PCT/ISA/210 (second sheet) (April 2005)

**INTERNATIONAL SEARCH REPORT**

International application No.

PCT/JP2006/324540

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2004-64757 A  (HUGHES ELECTRONICS CORP.),<br>26 February, 2004 (26.02.04),<br>Par. Nos. [0035] to [0043]<br>& US 2004/0028002 A1     & KR 4010115 A<br>& CN 1492598 A           & US 6829308 B2<br>& EP 1387496 A2 | 1-48 |

Form PCT/ISA/210 (continuation of second sheet) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Text Proposal on Adaptive Modulation and Channel Coding Rate Control for Frequency Domain Scheduling in Evolved UTRA Downlink. *3GPP TSG-RAN WG1 #43,* 07 November 2005

- Text proposal for 7.1.1.2.2 (Downlink reference-signal structure. *3GPP TSG-RAN WG1 #43,* 07 November 2005